(19) Europäisches Patentamt
European Patent Office
Office européen des brevets

(11) **EP 4 305 454 B1**

(12) **FASCICULE DE BREVET EUROPEEN**

(45) Date de publication et mention
de la délivrance du brevet:
**25.12.2024 Bulletin 2024/52**

(51) Classification Internationale des Brevets (IPC):
**G01S 7/4914** *(2020.01)*   **G01B 9/02** *(2022.01)*
**G01S 17/894** *(2020.01)*   **H03G 3/30** *(2006.01)*

(21) Numéro de dépôt: **22714177.7**

(52) Classification Coopérative des Brevets (CPC):
**H03F 3/087; G01S 7/4913; G01S 7/4917;
G01S 17/34; H03G 3/3084;** H03G 2201/106

(22) Date de dépôt: **11.03.2022**

(86) Numéro de dépôt international:
**PCT/EP2022/056414**

(87) Numéro de publication internationale:
**WO 2022/189665 (15.09.2022 Gazette 2022/37)**

(54) **DISPOSITIF DE CONVERSION D'UN SIGNAL PHOTONIQUE, LIDAR ET PROCÉDÉ ASSOCIÉS**

VORRICHTUNG ZUR UMWANDLUNG EINES PHOTONISCHEN SIGNALS, ZUGEHÖRIGER LIDAR UND VERFAHREN

DEVICE FOR CONVERTING A PHOTONIC SIGNAL, ASSOCIATED LIDAR AND METHOD

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **12.03.2021 FR 2102459**

(43) Date de publication de la demande:
**17.01.2024 Bulletin 2024/03**

(73) Titulaire: **Commissariat à l'Energie Atomique et
aux Energies
Alternatives
75015 Paris (FR)**

(72) Inventeur: **DUPONT, Bertrand
38054 GRENOBLE CEDEX 9 (FR)**

(74) Mandataire: **Lavoix
2, place d'Estienne d'Orves
75441 Paris Cedex 09 (FR)**

(56) Documents cités:
**EP-A2- 1 589 536        US-A1- 2003 076 484
US-A1- 2011 228 280**

EP 4 305 454 B1

**Description**

La présente invention concerne un dispositif de conversion d'un signal photonique, ainsi qu'un lidar comprenant un tel dispositif de conversion et une plate-forme mobile équipée d'un tel lidar. La présente invention concerne également un procédé de commande d'un tel dispositif de conversion.

Des dispositifs de conversion d'un signal photonique sont utilisés de manière courante dans des dispositifs optiques tels que des lidars, afin de générer un signal électrique fonction du signal photonique.

En particulier, dans certaines applications, le signal photonique est divisé en deux parties qui sont chacune transmise à une photodiode correspondante, l'une des deux parties étant déphasée d'environ 180 degrés par rapport à l'autre. Ainsi, la comparaison des courants de sortie des deux photodiodes, notamment la soustraction de ces deux courants, permet d'éliminer la composante continue (qui n'est pas affectée par le déphasage) du courant résultant pour n'en conserver que la partie variable. Le courant électrique résultant de la comparaison des courants de sortie des deux photodiodes est ensuite amplifié avant d'être analysé pour en extraire l'information recherchée.

De tels montages permettent donc « d'extraire un signal électrique alternatif à partir du mélange entre deux signaux photoniques. Ces montages sont notamment utilisés dans des lidars du type FMCW (de l'anglais « Frequency Modulation Continuous Wave »), qui utilisent l'émission d'un signal photonique dont la fréquence varie dans le temps. Ainsi, lorsque le signal photonique émis est renvoyé ou diffusé par une cible, la différence de fréquence entre le signal renvoyé ou diffusé reçu à un instant par le lidar et le signal émis au même instant est fonction de la distance entre le lidar et la cible. En particulier, le mélange du signal émis et du signal reçu forme un signal photonique dont on peut extraire, après passage par les photodiodes, un signal électrique dont la partie variable présente une fréquence de battement qui est fonction de la différence entre les fréquences des deux signaux mélangés et donc de la distance entre le lidar et la cible.

US 2011/0228280 A1 concerne un dispositif de conversion d'un signal photonique, du type précité.

Cependant, les montages utilisés dans les dispositifs de conversion existants ne sont pas optimisés. En particulier, lorsque le signal électrique à analyser comporte une composante continue ou variant lentement, la partie variable du signal électrique est souvent difficile à amplifier suffisamment sans saturer le dispositif lorsqu'elle présente une amplitude faible.

Il existe donc un besoin pour un dispositif de conversion d'un signal photonique qui permette l'analyse de signaux électriques correspondant dont la partie variable présente une amplitude plus faible que les dispositifs de conversion de l'état de la technique.

A cet effet, il est proposé un dispositif de conversion d'un signal photonique à analyser, selon la revendication 1.

Selon des modes de réalisation avantageux mais non obligatoires, le dispositif de conversion est selon l'une quelconques des revendications 2 à 11.

Il est également proposé un lidar selon la revendication 12.

Il est également proposé un procédé de commande selon la revendication 13.

Des caractéristiques et avantages de l'invention apparaîtront à la lecture de la description qui va suivre, donnée uniquement à titre d'exemple non limitatif, et faite en référence aux dessins annexés, sur lesquels :

- la figure 1 est une représentation schématique partielle d'un premier exemple de lidar, comportant un dispositif de conversion selon l'invention,
- la figure 2 est une représentation plus détaillée du lidar de la figure 1, et notamment du dispositif de conversion,
- la figure 3 est un ordinogramme des étapes d'un procédé de commande du dispositif de conversion de la figure 1,
- la figure 4 est une représentation schématique partielle d'un deuxième exemple de lidar selon l'invention,
- la figure 5 est une représentation schématique partielle d'un troisième exemple de lidar selon l'invention,
- la figure 6 est une représentation schématique partielle d'un deuxième exemple de lidar selon l'invention, et
- la figure 7 est une vue analogue à celle de la figure 6, selon une variante établie à partir de l'exemple de la figure 5.

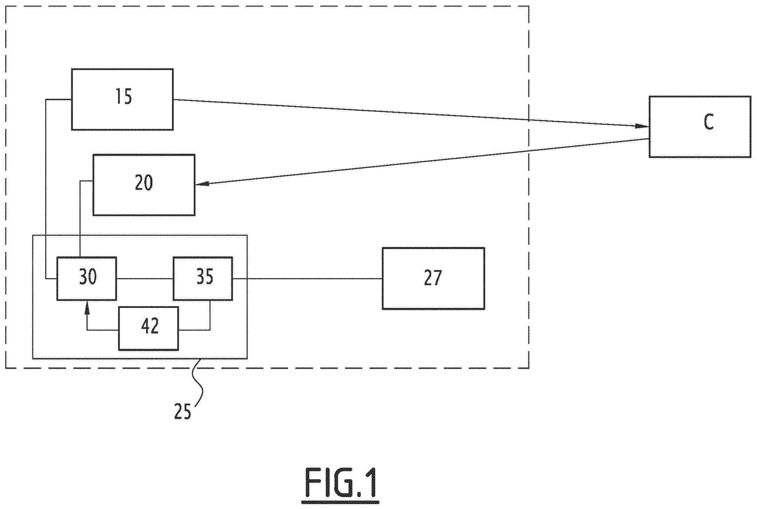

Un premier exemple de lidar 10 est représenté partiellement sur la figure 1.

Le lidar 10 est, par exemple, embarqué dans une plate-forme mobile telle qu'un véhicule, notamment dans un aéronef tel qu'un avion ou un hélicoptère, ou encore dans un satellite.

En variante, le lidar 10 est embarqué dans un véhicule terrestre, ou encore fixé à une structure fixe telle qu'un bâtiment.

Le lidar 10 comporte un étage d'émission 15, un étage de réception 20, un dispositif de conversion 25 et un dispositif d'analyse 27.

L'étage d'émission 15 est, de manière connue en soi, configuré pour émettre un premier signal vers une cible C. Egalement de façon connue en soi, les étages d'émission 15 et de réception 20 peuvent partager certains composants matériels, par exemple un éventuel dispositif d'orientation du signal émis et/ou reçu.

Le premier signal est un signal photonique. Par « signal photonique », on entend un signal comportant une onde électromagnétique dont la longueur d'onde dans le vide est comprise, par exemple, entre 100 nm et 20 μm.

L'étage d'émission 15 est, en particulier, configuré pour modifier la longueur d'onde du signal émis au cours du temps. Dans ce cas, le lidar 10 est un lidar de type « FMCW ».

Par exemple, l'étage d'émission 15 est configuré pour modifier la longueur d'onde du signal photonique de telle manière que la fréquence temporelle associée à la longueur d'onde varie selon une fonction temporelle continue par morceaux. Selon un mode de réalisation, la fonction est une fonction périodique, dans laquelle la fréquence augmente ou diminue linéairement en fonction du temps pendant une plage temporelle répétée périodiquement dans le temps.

Les plages temporelles sont, par exemple, répétées périodiquement avec une fréquence comprise entre 1 microseconde (μs) et 1 milliseconde (ms).

La cible C est propre à diffuser le premier signal émis par l'étage d'émission 15. La cible C est mobile ou immobile.

L'étage d'émission 15 est, en outre, configuré pour injecter une partie du signal émis dans le dispositif de conversion 25.

Par exemple, l'étage d'émission 15 comporte une source lumineuse, telle qu'un laser, configurée pour émettre le premier signal et est configuré pour dériver une partie de la lumière émise par la source lumineuse et pour conduire cette partie jusqu'au dispositif de conversion 25. La partie du signal dérivée est en général fonction de la puissance du signal laser, et on peut avoir des systèmes où la puissance de la partie dérivée correspond à environ 1 % de la puissance du signal laser émis.

L'étage de réception 20 est configuré pour recevoir un deuxième signal photonique. Le deuxième signal photonique est le signal diffusé par la cible C lorsque la cible C est illuminée avec le premier signal. Puisque la cible C est distante du lidar 10, le deuxième signal présente une fréquence différente de la fréquence du premier signal, la différence entre ces deux fréquences étant fonction de la distance entre le lidar 10 et la cible C.

L'étage de réception 20 est, en outre, configuré pour conduire le deuxième signal photonique reçu jusqu'au dispositif de conversion 25.

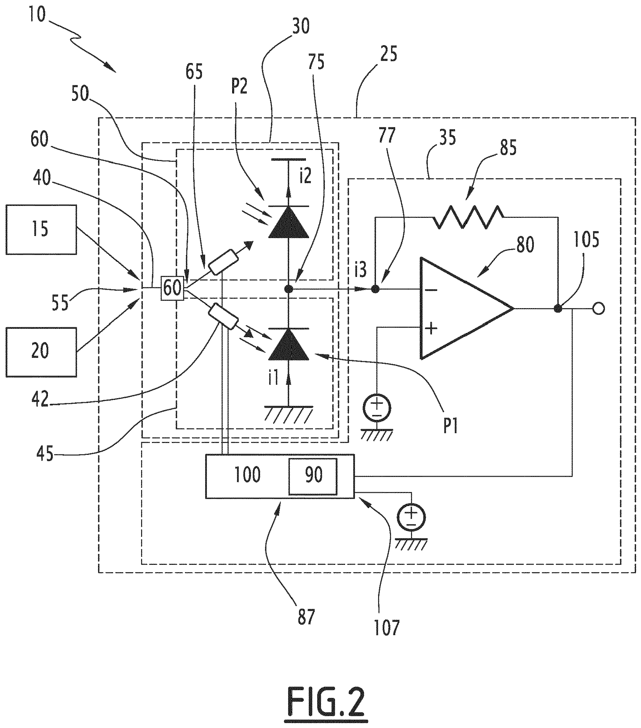

Le dispositif de conversion 25, représenté plus en détails sur la figure 2, est configuré pour convertir en tension un troisième signal photonique. Le troisième signal photonique est formé par le mélange du deuxième signal et de la partie du premier signal qui est transmise au dispositif de conversion 25, comme il apparaîtra par la suite.

En particulier, le dispositif de conversion est configuré pour générer en sortie une tension électrique qui sera analysée par le dispositif d'analyse 27 pour calculer des valeurs d'au moins un paramètre à partir du troisième signal.

Chaque paramètre est, par exemple, choisi parmi le groupe formé de : une distance entre la cible C et le lidar 10, une vitesse relative de la cible C par rapport au lidar 10, une valeur d'albedo de la cible C (en analysant notamment l'amplitude du signal).On notera que si le troisième signal photonique était converti en signal électrique par l'intermédiaire d'une photodiode, le signal électrique correspondant comporterait une partie DC et une partie AC. Le troisième signal photonique est par essence un signal alternatif et ne comporte pas à proprement parler une partie DC. La partie DC d'un signal électrique correspondant est en pratique une image de l'énergie « efficace » véhiculée par le signal photonique. Par la suite, nous utiliserons par simplification de langage, l'expression partie continue DC d'un signal photonique pour faire référence à une composante DC d'un signal électrique correspondant qui serait généré par une photodiode recevant ce signal photonique. De même, nous utiliserons l'expression partie AC d'un signal photonique pour faire référence à une composante AC d'un signal électrique correspondant qui serait généré par une photodiode recevant ce signal photonique.

Le troisième signal comporte une partie variable et une partie continue, notamment pendant l'émission du premier signal.

La partie variable présente une puissance optique variant au cours du temps. La partie variable résulte notamment du mélange des signaux reçus de l'étage d'émission 15 et de l'étage de réception 20 et présente une fréquence de battement causée par la différence entre les fréquences du premier signal et du deuxième signal. C'est l'analyse ultérieure de la fréquence de battement qui permet de déduire, de manière connue, la distance entre la cible C et le lidar 10.

La puissance photonique d'un signal photonique est définie comme étant l'énergie reçue par unité de temps par une surface illuminée avec ledit signal photonique.

Le dispositif de conversion 25 comporte un organe de conversion 30 qui comporte les éléments permettant de passer d'un flux photonique à un courant électrique, un dispositif de traitement 35 et au moins un organe de réglage 42.

L'organe de conversion 30 comporte une branche d'entrée 40, un séparateur 60, et un couple de branches de sorties 45, 50, le couple comportant une première branche de sortie 45 et une deuxième branche de sortie 50.

La branche d'entrée 40 est configurée pour recevoir le troisième signal et l'apporter au séparateur 60.

Le séparateur 60 est configuré pour conduire une première partie du troisième signal reçu à la première branche de sortie 45 et pour conduire une deuxième partie du troisième signal à la deuxième branche de sortie 50.

Par exemple, la branche d'entrée 40 présente une extrémité 55 dans laquelle arrive le flux photonique du troisième signal, ce flux étant guidé jusqu'au séparateur 60 par la branche principale 40.

Comme cela est connu de l'homme de l'art, on notera qu'il est possible d'utiliser un séparateur 60 à deux entrées pour recevoir les signaux à mélanger issus des étages d'émission 15 et de réception 20, le mélange étant réalisé à l'intérieur du séparateur 60 avant ou pendant les opérations à proprement parler de séparation et de déphasage.

Selon les modes de réalisation représentés sur les figures, l'organe de conversion 30 comporte une unique première branche 45 et une unique deuxième branche 50, toutefois il est à noter que l'on pourrait avoir plusieurs couples de branches comme cela sera précisé infra.

De manière connue en soi, l'organe de conversion 30, et notamment le séparateur 60, est configuré pour imposer un déphasage d'environ 180 degrés (°) entre la première partie et la deuxième partie du troisième signal.

Il est notamment entendu par « environ 180° » un déphasage compris par exemple entre 170° et 190°, en particulier entre 175° et 185°.

L'organe de conversion 30 est configuré pour fixer un rapport entre la puissance de la première partie et la puissance de la deuxième partie.

L'organe de conversion 30 est, par exemple, configuré pour que la puissance de la première partie et la puissance de la deuxième partie soient égales l'une à l'autre, à 5 pourcents (%) près, voire à 2 % près.

Chaque première ou deuxième branche de sortie 45, 50 est, en outre, configurée pour générer respectivement, grâce à une photodiode P1 ou P2 correspondante, un courant électrique i1 ou i2 en réponse à la réception de la première ou deuxième partie correspondante du troisième signal. Le courant généré par la branche de sortie 45 sera nommé i1 et le courant généré par la branche de sortie 50 sera nommé i2 par la suite.

En particulier, l'intensité de chaque courant électrique i1 ou i2 est une fonction de la puissance optique de la première ou deuxième partie du troisième signal reçue par la première ou deuxième branche de sortie 45, 50 considérée.

Chacune de la première branche de sortie 45 et de la deuxième branche de sortie 50 comporte une portion de guide d'onde 65 et une photodiode P1, P2. La première branche de sortie 45 comprend une première photodiode P1, et la deuxième branche de sortie 50 comprend une deuxième photodiode P2.

La portion de guide d'onde 65 de la première branche de sortie 45 est configurée pour recevoir la première partie du troisième signal et pour illuminer la photodiode P1. La portion de guide d'onde 65 de la deuxième branche de sortie 50 est configurée pour recevoir la deuxième partie du troisième signal et pour illuminer la photodiode P2.

Les portions de guide d'onde 65 des branches de sortie 45 et 50 sont reliées à la branche d'entrée 40 par le séparateur 60 réalisant une séparation et un déphasage respectif. Un tel dispositif séparateur 60 correspond par exemple à un « interféromètre multi-modes » (en Anglais « Multi-Mode Interferometer », ou « MMI »)

Il est défini, pour chaque première ou deuxième branche de sortie 45, 50, un facteur de transmission photonique égal à un rapport entre, au numérateur, la puissance optique de la première ou deuxième partie du troisième signal en sortie de la portion de guide d'onde 65 et, au dénominateur, la puissance optique de la première ou deuxième partie du troisième signal en entrée de la portion de guide d'onde 65.

En d'autres termes, le facteur de transmission photonique d'une première ou deuxième branche de sortie 45, 50 est un rapport entre, au dénominateur, la puissance optique du signal injecté par la branche principale dans la première ou deuxième branche de sortie 45, 50 et, au numérateur, la puissance optique du signal illuminant la photodiode P1, P2 de la première ou deuxième branche de sortie 45, 50 considérée.

Chaque photodiode P1 ou P2 est configurée pour générer le courant électrique i1 ou i2 lorsqu'elle est illuminée respectivement avec la première ou deuxième partie du troisième signal.

Il est défini une efficacité quantique (en Anglais, « Quantum Efficiency ») pour chaque photodiode P1, P2.

L'efficacité quantique de chaque photodiode P1, P2 est définie comme étant égale à un rapport entre, au numérateur, le nombre de porteurs de charge générés par unité de temps et, au dénominateur, le nombre de photons illuminant la photodiode pendant la même unité de temps.

Chaque photodiode P1, P2 présente une anode et une cathode. Le courant électrique i1 ou i2 généré par la photodiode P1, P2 traverse la photodiode, et nous considérons un sens arbitraire positif quand le courant circule de l'anode à la cathode.

Le dispositif de conversion 25 est configuré pour imposer une différence de potentiel entre l'anode et la cathode de chaque photodiode P1, P2.

Dans le premier exemple de lidar 10, les photodiodes P1, P2 des deux branches sont montées en série dans le même sens l'une avec l'autre. Dans ce cas, le dispositif de conversion 25 est, par exemple, configuré pour imposer une tension électrique entre deux extrémités d'un circuit électrique série comportant les deux photodiodes P1, P2.

En particulier, une portion de circuit électrique est connectée à l'anode de l'une des photodiodes (la photodiode P2) et à la cathode de l'autre photodiode (la photodiode P1).

Dans le premier exemple de dispositif la portion de circuit électrique est, par exemple, un conducteur électrique reliant l'anode de la photodiode P2 à la cathode de la photodiode P1.

Il est défini un point 75, appelé par la suite « point milieu », de ladite portion de circuit électrique.

Dans cet exemple, la cathode de la photodiode P1 est connectée au point 75, dont le potentiel électrique est régulé. L'anode de la photodiode P1 est par exemple reliée à la terre, comme représenté sur la figure 2

Une borne d'une source de tension (Vdd) est connectée à la cathode de la photodiode P2, son anode étant reliée au point milieu 75.

Le dispositif de traitement 35 est configuré pour recevoir en entrée un courant i3.

Dans l'exemple représenté en figure 2, selon la loi des mailles, le courant I3 est égal au courant i2 moins le courant i1.

Le dispositif de traitement 35 est configuré pour amplifier le courant i3 et pour générer un signal électrique de sortie, le signal électrique de sortie étant fonction de l'intensité du courant i3.

Par exemple, la tension électrique du signal électrique de sortie est proportionnelle à l'intensité du courant i3, et donc à la différence entre les intensités des courants i1 et i2.

Ainsi, en l'absence de saturation ou d'autres non-linéarités du dispositif de traitement 35, la partie variable de la tension électrique du signal électrique de sortie varie linéairement en fonction de la puissance optique de la partie variable du troisième signal.

Il est défini un gain pour chaque première ou deuxième branche de sortie 45, 50. Le gain est le coefficient de proportionnalité entre l'intensité du courant électrique i1 ou i2 associé à une branche 45 ou 50 et la puissance optique de la partie du troisième signal injectée dans la branche considérée.

En d'autres termes, l'intensité I du courant électrique i1 ou i2 généré est reliée à la puissance optique P du signal correspondant par l'équation suivante :

$$[\text{Math 1}] \qquad I = a*P + b$$

dans laquelle a est une constante, b est un nombre réel, et * représente l'opération de multiplication.

La constante a est alors le coefficient de proportionnalité entre I et P, ou « gain de branche».

Il est à noter que le terme « coefficient de proportionnalité » est utilisé ici pour représenter tout coefficient reliant la variation d'une grandeur à la variation d'une autre grandeur, indépendamment de la valeur du nombre b. Il est à noter que le nombre b est en pratique négligeable devant le terme a*P quand la puissance optique P est significative et notamment comprise sur une plage de variations de puissance d'entrée du troisième signal considérée dans la présente invention. Ainsi, on pourra considérer dans la suite des explications, que le courant électrique fourni par une photodiode est proportionnel à la puissance optique P.

Le dispositif de traitement 35 comporte une entrée 77, un amplificateur 80, un dipôle résistant 85 et une boucle de régulation 87 comportant un filtre 90 et un contrôleur 100.

Le dispositif de traitement 35 est un dispositif électronique, c'est-à-dire un dispositif configuré pour traiter et/ou générer des données, des messages ou des commandes sous la forme de signaux électriques.

Par exemple, l'entrée 77, l'amplificateur 80, le dipôle résistant 85 et la boucle de régulation 87 sont au moins partiellement formés par un ou des circuit(s) électrique(s), porté(s) par une ou plusieurs carte(s) de circuit imprimé ou autre support fonctionnalisable. Le ou les circuits électriques peuvent par exemple être des circuits intégrés réalisés en technologie CMOS éventuellement reliés et alimentés via un interposeur semiconducteur ou équivalent.

En variante ou en complément, le dispositif de traitement 35 comporte une unité de traitement de données, qui peut comprendre un processeur et une mémoire contenant des instructions logicielles destinées à être traitées par le processeur. Ce processeur peut éventuellement être utilisé pour réaliser tout ou partie du filtre 90 et/ou du contrôleur 100.

L'entrée 77 est configurée pour recevoir le courant électrique i3

Par exemple, l'entrée 77 est électriquement connectée au point milieu 75.

L'amplificateur 80 est de type « amplificateur opérationnel ».

L'amplificateur 80 comporte une entrée non inverseuse +, une entrée inverseuse - et une sortie 105.

La sortie 105 est unique dans le premier exemple de dispositif de conversion 25. De telles architectures d'amplificateurs 80 sont fréquemment dénommées par l'expression anglaise « single output differential amplifier ».

L'amplificateur 80 est configuré pour générer le signal électrique de sortie. En particulier, l'amplificateur 80 est configuré pour modifier la tension électrique entre la sortie 105 et une référence de potentiel électrique, telle qu'une borne de mise à la terre de l'amplificateur 80, en fonction du courant i3.

L'entrée non inverseuse + est connectée à un point dont le potentiel électrique est sensiblement constant, dont la valeur est choisie notamment en fonction du montage formé par les photodiodes P1, P2.

Cependant, le potentiel électrique de l'entrée non inverseuse + peut être différent d'un dispositif de conversion 25 à un autre, en fonction notamment des alimentations électriques de l'amplificateur. Par exemple, si l'amplificateur 80 est alimenté entre deux potentiels électriques distincts sur ses broches d'alimentations, le potentiel électrique de l'entrée non inverseuse + est par exemple égal à, ou proche de, la moyenne des deux potentiels électriques des broches.

Dans le cas où les alimentations électriques sont polarisées avec des potentiels électriques de signes opposés et de même valeur absolue, le potentiel électrique de l'entrée non inverseuse + est par exemple celui de la terre.

L'entrée inverseuse - est connectée à l'entrée 77 du dispositif de traitement. En particulier, l'entrée inverseuse - est connectée à l'entrée 77 de telle manière qu'elle présente un potentiel électrique identique à celui du point milieu 75.

Le dipôle résistant 85 est électriquement connecté, à l'une de ses bornes, à la sortie 105 de l'amplificateur 80 et, à l'autre de ses bornes, à l'entrée 77. Ainsi, puisque le courant entrant dans l'entrée inverseuse - de l'amplificateur 80 est nul, le courant circulant entre la sortie 105 de l'amplificateur 80 et l'entrée 77 est égal, en intensité, au courant i3.

Le potentiel électrique de l'entrée 77 et du point milieu 75 est donc maintenu par l'amplificateur 80, via la modification du potentiel de la sortie 105.

Le dipôle résistant 85 présente une valeur de résistance électrique comprise, par exemple, entre 1 kiloOhm (KΩ) et 1 mégOhm (MΩ).

L'ensemble formé par l'amplificateur 80 et le dipôle résistant 85 connecté entre la sortie 105 et l'entrée inverseuse - de l'amplificateur 80 est parfois appelé en Anglais « résistive transimpedance amplifier » ou « RTIA ».

La boucle de régulation 87 est configurée pour agir sur au moins un organe de réglage 42 en fonction de la valeur de la tension en sortie de l'amplificateur 80.

La boucle de régulation 87 peut être une boucle de régulation analogique ou numérique ou encore mixte.

Lorsque la boucle de régulation 87 est une boucle numérique, elle comporte par exemple un convertisseur analogique/numérique interposé entre la sortie 105 et le filtre 90.

Il est à noter que, bien que le filtre 90 et le contrôleur 100 soient décrits ici comme des dispositifs distincts, des modes de réalisation dans lesquels un unique dispositif présente les fonctions de ces deux éléments sont également envisageables.

Le filtre 90 est connecté à la sortie 105 de l'amplificateur 80 et est configuré pour générer un signal filtré à partir du signal électrique de sortie.

Le filtre 90 est un filtre passe-bas en fréquence.

Le filtre 90 présente, par exemple, une fréquence de coupure comprise entre 1 kilohertz (KHz) et 10 mégahertz (MHz). Toutefois, il est à noter que la fréquence de coupure du filtre 90 doit être adaptée à la plage de fréquence du signal utile AC que l'on souhaite récupérer en sortie de l'amplificateur

Le filtre 90 présente une fonction de transfert.

La fonction de transfert est par exemple celle d'un filtre actif de type PI, comprenant une partie intégrale et une partie proportionnelle.

La boucle de régulation 87 compare le signal de sortie reçue à une valeur de consigne pour définir une valeur d'erreur et génère une commande par l'unité de contrôle 100 tenant compte de cette erreur. Le filtre 90 est présent dans la boucle de régulation avant et/ou après la définition de l'erreur. En outre, bien que le filtre 90 soit présenté distinctement du circuit de contrôle 100, la fonction de filtrage peut être co-intégrée avec la fonction de contrôle, et répartie dans différents éléments constitutifs de la boucle de régulation. Il est important que la boucle de régulation 87 présente une fonction de filtre passe-bas afin de pouvoir supprimer la composante basse fréquence du signal 105 en sortie de l'amplificateur 80, cette composante basse fréquence étant par suite appelée « DC » par opposition à la composante « AC » du signal utile.

La valeur de consigne susmentionnée peut correspondre par exemple à la valeur souhaitée pour la moyenne temporelle de la tension de sortie 105.

La valeur de consigne est par exemple égale au potentiel électrique de l'entrée non inverseuse +. Ce choix permet généralement une excursion maximale du signal utile AC en sortie de l'amplificateur avant saturation.

Les différentes valeurs des coefficients de la fonction de transfert, ainsi que la valeur de consigne, sont susceptibles de varier ou d'être choisis en fonction des caractéristiques spécifiques du lidar 10 considéré.

Le contrôleur 100 est configuré pour déterminer, parmi les branches de sortie 45, 50, laquelle présente le gain le plus élevé et pour commander le ou les organes de réglage 42 en conséquence.

Par exemple, la boucle de régulation 87 présente une partie intégratrice dans la fonction de transfert du filtre 90. Les valeurs du signal filtré tendent, en présence d'un déséquilibre entre les courants i1 et i2, à dériver dans une direction (i.e en augmentant ou en diminuant) dépendant du sens du déséquilibre. Le contrôleur 100 compare chaque valeur du signal filtré acquise à un seuil minimal et un seuil maximal, et détermine quelle branche 45 ou 50 présente le gain le plus élevé lorsque l'une des valeurs est inférieure ou égale au seuil minimal ou supérieure ou égale au seuil maximal.

A l'initialisation du lidar, les organes de réglage 42 sont commandés avec une tension d'initialisation prédéfinie et la sortie de la partie intégratrice est réinitialisé à une tension de référence (égale dans cet exemple à la tension de régulation du noeud 77). Aucun dépassement des seuils minimal et maximal n'est constaté immédiatement, et par conséquent, les commandes des organes de réglage 42 restent inchangées.

Après un certain temps, la sortie de la partie intégratrice va dériver dans un sens selon le déséquilibre des courants, et un seuil minimal ou maximal va être franchi, entrainant par ricochet la modification du signal de commande d'un organe de réglage 42 dans le sens d'un ré-équilibrage des courants pour obtenir des courants i1 et i2 les plus grands possibles.

Si l'équilibre est trouvé, la sortie de la partie intégratrice reste normalement stable et par conséquent les commandes des organes de réglage n'évoluent plus. Si un déséquilibre s'établit au cours de temps, du fait par exemple de variations de la température, ou d'un problème sur le lidar (objet trop proche du lidar de façon non transitoire) alors la sortie de la partie intégratrice va à nouveau dériver.

Si la sortie de la partie intégratrice atteint une tension de saturation minimale ou maximale ne permettant plus de corriger le déséquilibre, alors il est possible de modifier la commande de l'autre organe de réglage 42 qui était jusquelà inchangée, pour retrouver une tension sur la sortie de la partie intégratrice non saturée.

Si la partie intégratrice dérive de façon opposée à celle précédemment constatée, en dépassant un autre des seuils minimal et maximal, il est alors possible de modifier l'action de commande, en « l'inversant », pour modifier un signal de commande d'un autre organe de réglage 42 dans le sens d'un ré-équilibrage des courants, toujours pour avoir de préférence les courants i1 et i2 les plus grands possibles.

Le seuil minimal est, par exemple, égale au potentiel du noeud 77-0.5 V. Le seuil maximal est, par exemple, égal au potentiel du noeud 77+ 0.5V.

En outre, selon une variante, l'une des branches de sortie 45, 50 génère par construction un courant électrique i1 ou i2 plus intense que celui de l'autre branche de sortie 45, 50. Dans ce cas, le contrôleur 100 n'a plus besoin de déterminer la branche 45 ou 50 présentant le gain le plus élevé.

Une telle boucle de régulation 87 est susceptible d'être réalisée soit sous forme numérique soit sous forme analogique, soit sous forme mixte analogique-numérique.

En outre, le type de signal de commande utilisé est également susceptible de varier, par exemple d'être un signal analogique ou numérique.

Le contrôleur 100 compare, par exemple, le signal filtré à une valeur de consigne prédéfinie, et génère la commande en fonction de la comparaison. La commande présente, par exemple, une tension ou une intensité proportionnelle à une différence entre le signal filtré et la valeur de consigne.

La valeur de consigne est, par exemple, une valeur telle que la sortie de l'amplificateur 80, et par ricochet le courant i3, contiennent une composante continue négligeable après un temps d'établissement de la boucle de régulation 87. La valeur de consigne est par exemple égale à 1,65 V ou à 0V, selon l'alimentation de l'amplificateur 80 et correspond de préférence au niveau de tension régulé du point milieu 75. La valeur de consigne est en pratique, dans cet exemple, fournie par un générateur de tension de consigne 107.

Selon une variante naturelle pour l'homme de l'art, et comme cela est le cas dans d'autres modes de réalisation infra, l'opération de comparaison à une valeur de consigne souhaitée prédéfinie peut être réalisée avant l'opération de filtrage, par exemple directement sur le signal de sortie 105.

Le contrôleur 100 est, en outre, configuré pour générer au moins une commande en fonction du signal filtré et pour transmettre chaque commande à l'organe de réglage 42 auquel la commande est destinée. Chaque commande est, par exemple, une commande de modification du gain, ou encore une commande de maintien du gain à une valeur constante, comme il apparaîtra par la suite.

Chaque commande est, notamment, un signal électrique tel qu'une tension électrique.

Il est à noter que le type de commande, le procédé utilisé pour la générer et ses caractéristiques sont susceptibles d'être adaptés par l'homme du métier en fonction de la situation, notamment en fonction du type d'organe de réglage 42 utilisé.

Selon le mode de réalisation représenté sur la figure 2, le dispositif de conversion 25 comporte deux organes de réglages 42, un pour chaque branche de sortie 45, 50. Cependant, selon des variantes envisageables, le dispositif de conversion 25 comporte un unique organe de réglage 42 associé, par exemple, à une seule des branches de sortie 45, 50.

Chaque organe de réglage 42 est configuré pour modifier le gain de la première ou deuxième branche de sortie 45, 50 correspondante.

Selon le mode de réalisation représenté sur la figure 2, chaque organe de réglage 42 est configuré pour modifier le facteur de transmission photonique de la première ou deuxième branche de sortie 45, 50 correspondante.

Par exemple, chaque organe de réglage 42 est un atténuateur, configuré pour absorber une partie du signal photonique se propageant dans la portion de guide d'onde 65 correspondante, ou encore un amplificateur configuré pour augmenter la puissance optique du signal photonique se propageant dans la portion de guide d'onde 65 correspondante.

Des atténuateurs commandables électroniquement pour modifier l'atténuation d'un signal photonique dans un guide d'onde optique sont utilisés dans de nombreuses applications telles que les télécommunications. De tels atténuateurs comportent, par exemple, une portion de guide d'onde dans laquelle, via une jonction p-n, l'atténuateur est prévu pour modifier une densité volumique de porteurs de charge libres, l'atténuation du signal dépendant de la densité de porteurs de charge présents. Ainsi, une commande reçue par l'atténuateur pour modifier la densité de porteur de charges libres se traduit par une variation du facteur de transmission photonique dans le guide d'onde.

Le dispositif d'analyse 27 est, de manière connue en soi, configuré pour calculer des paramètres de la cible C, par exemple une distance entre la cible C et le lidar 10 et/ou une vitesse relative de la cible C par rapport au lidar 10, en fonction du signal électrique de sortie. Par exemple, le dispositif d'analyse 27 est électriquement connecté à la sortie 105 de l'amplificateur 80.

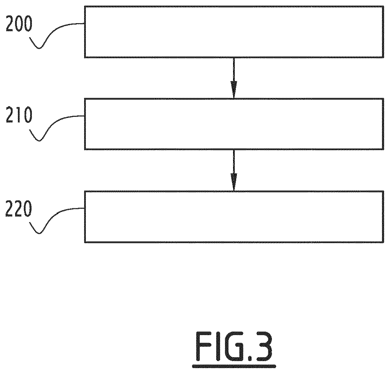

Le fonctionnement du lidar 10 va maintenant être décrit en référence à la figure 3, qui présente un logigramme des étapes d'un procédé de commande du dispositif de conversion 25.

Le procédé de commande comporte une étape 200 de filtrage, une étape 210 de génération et une étape 220 de transmission et de modification.

Au cours des étapes 200 à 220, le premier signal photonique et le deuxième signal photonique sont générés par l'étage d'émission 15 et par l'étage de réception 20, respectivement.

Le troisième signal se propageant dans la branche d'entrée 40 est alors le mélange d'une partie du premier signal photonique émis vers la cible C et du deuxième signal photonique diffusé par la cible C.

Le troisième signal est divisé dans l'organe de conversion 30 en une première partie circulant dans la première branche de sortie 45 et une deuxième partie circulant dans la deuxième branche de sortie 50. L'illumination de chacune des photodiodes P1, P2 avec une des première et deuxième parties du troisième signal entraîne donc la génération, par chaque photodiode P1, P2, du courant électrique i1 ou i2 correspondant.

Chaque courant électrique i1 ou i2 comporte une partie variable et une partie continue, ces courants sont fonction respectivement de la première ou deuxième partie du troisième signal qui a causé la génération du courant électrique i1 ou i2 considéré.

Un courant électrique i3 présentant une intensité égale à la différence entre les intensités des courants électriques i1 et i2 circule entre le point milieu 75 et l'entrée 77 du dispositif de traitement 35.

Si le troisième signal était divisé également par le guide d'onde 35 entre la première branche de sortie 45 et la deuxième branche de sortie 50, et si les deux photodiodes P1 et P2 étaient rigoureusement identiques, les parties continues des deux courants i1 et i2 seraient égales l'une à l'autre.

Puisqu'un déphasage proche de 180° est imposé entre les première et deuxième parties du troisième signal, les parties variables des premiers courants électriques sont également déphasées de 180 ° l'une par rapport à l'autre. Aussi, si le troisième signal était divisé également par le guide d'onde 35 entre la première branche de sortie 45 et la deuxième branche de sortie 50 et si les deux photodiodes P1, P2 étaient rigoureusement identiques, les parties variables des courants électriques i1 et i2 seraient inverses l'un de l'autre.

Ainsi, dans un cas idéal où le troisième signal était divisé également par le séparateur 60 entre la première branche de sortie 45 et la deuxième branche de sortie 50 et si les deux photodiodes P1, P2 étaient rigoureusement identiques, le courant i3 circulant entre le point milieu 75 et l'entrée 77, correspondant à la différence entre les courants i1 et i2, ne présenterait aucune composante continue et serait un courant purement variable, dont l'intensité serait égale au double de l'intensité de la partie variable de chacun des courants i1 et i2.

Le signal de sortie de l'amplificateur 80, notamment la tension électrique entre la sortie 105 et un point de référence électrique, serait alors un signal variable sans composante continue, résultant de l'amplification du courant électrique i3 reçu sur l'entrée 77.

Toutefois, le séparateur 60 n'est jamais parfait.

Lorsque le troisième signal est divisé inégalement par le séparateur 60 entre la première branche de sortie 45 et la deuxième branche de sortie 50, ou lorsque l'efficacité quantique d'une photodiode P1, P2 diffère de celle de l'autre photodiode P1, P2, les parties continues des deux courants i1 et i2 ne sont pas égales, et une composante continue subsiste donc dans le courant électrique i3 reçu sur l'entrée 77.

Le signal électrique de sortie généré par l'amplificateur 80 présente donc, outre une partie variable dont le dispositif d'analyse 27 est configuré pour extraire des informations concernant la cible C, une partie continue résultant de la différence entre les deux courants i1 et i2.

Lors de l'étape de filtrage 200, le signal filtré est généré par le filtre 90 à partir du signal de sortie. En particulier, puisqu'une partie continue peut être présente dans le signal de sortie, le signal filtré comporte au moins une composante correspondant à ladite partie continue. Par exemple, le signal filtré comporte la partie continue du signal de sortie.

Lors de l'étape de génération 210, le contrôleur 100 génère une commande à destination d'au moins un organe de réglage 42 à partir du signal filtré.

Par exemple, le contrôleur 100 génère une commande à destination de chacun des organes de réglage 42.

En particulier, lorsque les organes de réglage 42 sont des atténuateurs, le contrôleur 100 génère par exemple une commande de diminution du gain (en pratique, un gain inférieur à 1 puisqu'il s'agit d'un atténuateur) à destination de l'organe de réglage 42 correspondant à la branche de sortie 45, 50 dont le courant i1 ou i2 présente la composante continue la plus intense et une commande de maintien inchangé du gain à destination de l'organe de réglage 42 correspondant à la première ou deuxième branche de sortie 45, 50 dont le courant i1 ou i2 présente la composante continue la moins intense.

En variante, si l'organe de réglage 42 est un amplificateur, le contrôleur 100 génère une commande d'augmentation du gain à destination de l'organe de réglage 42 correspondant à la branche de sortie 45, 50 dont le courant i1 ou i2 présente la composante continue la moins intense et une commande de maintien inchangé du gain à destination de l'organe de réglage 42 correspondant à la première ou deuxième branche de sortie 45, 50 dont le courant i1 ou i2 présente la composante continue la plus intense.

Si une commande respective est générée pour au moins deux organes de réglage 42, les commandes sont propres à entraîner des modifications différentes, par lesdits organes de réglage 42, des gains des branches de sortie 45, 50 associées aux organes de réglage 42 considérés.

Selon une autre variante, une unique commande d'augmentation ou de diminution du gain est émise à destination, par exemple si un seul organe de réglage 42 est présent.

Ainsi, le gain d'une seule des deux première ou deuxième branche de sortie 45, 50 est modifiée.

Au cours de l'étape 220, la ou chaque commande est transmise à l'organe de réglage 42 correspondant. L'organe de réglage 42 modifie alors le facteur de transmission photonique, et donc le gain de la première ou deuxième branche de sortie 45, 50 correspondante.

Les étapes 200 à 220 sont répétées jusqu'à ce que la composante continue présente dans le courant i3 soit telle que la ou les commande(s) générée(s) par le contrôleur 100 n'entraîne pas de modification du facteur de transmission photonique des branches de sortie 45, 50, par exemple lorsque chaque commande générée est une commande de maintien inchangé du gain.

En particulier, les étapes 200 à 220 sont réitérées en continu, de sorte que les gains des deux branches de sortie 45, 50 soient sensiblement égaux, de manière à ce que le courant i3 ne comporte qu'une composante continue négligeable ou indétectable.

Dans les dispositifs de l'état de la technique, les guides d'onde utilisés pour conduire le signal photonique à analyser et pour le séparer en deux parties sont nécessairement imparfaits et ne permettent pas de diviser exactement le signal photonique en deux parties égales, et la puissance des signaux illuminant les deux photodiodes P1, P2 est donc en général légèrement différente d'une photodiode P1, P2 à l'autre. En outre, les rendements des deux photodiodes P1, P2 sont susceptibles de différer légèrement l'un de l'autre.

De par ces imperfections, le signal résultant de la soustraction des courants des deux photodiodes P1, P2, qui devrait idéalement ne comprendre qu'une partie variable fonction de la différence de fréquence entre les signaux photoniques reçus et émis, comporte en général une composante continue non négligeable.

Lorsque la partie variable du signal à analyser est très faible, par exemple lorsque la cible C est très éloignée du lidar, la composante continue est susceptible d'être très supérieure à la partie variable. En conséquence, la capacité du dispositif de conversion à analyser des signaux dont la partie variable est très faible est limitée par la présence de cette composante continue, puisque la chaine risque d'être saturée par la composante continue du signal électrique alors que la composante variable reste inférieure au niveau requis pour en faire l'analyse.

Selon l'invention, la boucle de régulation 87 agissant sur le ou les organes de réglage 42 permet de réduire très fortement la composante continue résultant, dans le courant i3, de l'imperfection de l'organe de conversion 30. Aussi, l'amplificateur 80 peut être choisi pour amplifier très fortement la composante variable contenant l'information recherchée, sans que la composante continue subsistante ne sature l'amplificateur 80. Il est alors possible d'analyser précisément la composante variable du courant i3 même avec un deuxième signal très faible provenant d'une cible C lointaine ou diffusant peu le premier signal photonique.

En outre, puisqu'un ou plusieurs gains sont modifiés pour parvenir à ce résultat, une modification de la puissance des premier et deuxième signaux (modification qui peut résulter d'une variation de la puissance photonique du premier signal émis par exemple) n'oblige pas à réitérer le procédé de commande. En cela, le procédé est plus précis et rapide qu'un procédé qui compenserait le courant i3 DC par l'injection d'un courant électrique additionnel (ou la soustraction d'un courant) en sortie du pont de diodes P1, P2 et effectuerait donc une correction dite « en offset », puisque la valeur du courant électrique additionnel devrait être adaptée à chaque modification de l'intensité des premier et deuxième signaux.

En particulier, la régulation permet d'annuler la composante continue dans le courant i3 selon l'équation :

$$[\text{Math 2}] \qquad i3_{DC} = i1_{DC} - i2_{DC} = 0$$

Dans laquelle $i3_{DC}$ est l'intensité de la composante continue de i3, $i2_{DC}$ est l'intensité de la composante continue de i2 et $i1_{DC}$ est l'intensité de la composante continue de i1.

La correction en gain selon l'invention revient à agir sur un ou les gain(s) des branches 45 et 50 pour satisfaire l'équation :

$$[\text{Math 3}] \qquad i3_{DC} = A1 \times QE_1 \times P_{1DC} - A2 \times QE_2 \times P_{2DC} = 0$$

Dans laquelle A1 est le gain de la branche 45, $QE_1$ est le rendement quantique de la photodiode P1, $P_{1DC}$ est la puissance de la partie continue du signal photonique entrant dans la branche 45, A2 est le gain de la branche 45, $QE_2$ est le rendement quantique de la photodiode P2, et $P_{2DC}$ est la puissance de la partie continue du signal photonique entrant dans la branche 50.

Puisque $P_{1DC}$ et $P_{2DC}$ sont proportionnelles à l'intensité de la puissance du troisième signal (c'est-à-dire du signal total entrant dans l'organe de conversion 30) et le coefficient de proportionnalité est fixé par construction, il n'est pas nécessaire de modifier A1 ou A2 si la puissance du troisième signal varie.

Au contraire, une régulation « en offset », comme proposé dans l'état de la technique, revient à ajouter un courant $i_{fb}$ selon l'équation :

$$[\text{Math 4}] \qquad i3_{DC} = QE_1 \times P_{1DC} - QE_2 \times P_{2DC} - i_{fb} = 0$$

Il en résulte que, en cas de correction « en offset », si l'intensité du signal photonique injecté dans l'organe de conversion 30 (et donc la valeur de $P_{1DC}$ et $P_{2DC}$) varie, il est nécessaire d'ajuster l'intensité du courant $i_{fb}$. En cas de variation rapide de l'intensité du signal, un lidar utilisant une correction en offset risque donc de saturer pendant une certaine période (jusqu'à ce que $i_{fb}$ ait été ajusté), ce qui n'est pas le cas pour le lidar 10 selon l'invention.

Les facteurs de transmission photoniques de guides d'onde peuvent être modifiés de manière précise et permettent donc un réglage d'autant plus précis du gain de chaque branche de sortie 45, 50. L'utilisation d'un ou plusieurs organe(s) de réglage 42 agissant sur ce paramètre permet donc de renforcer la précision ou d'étendre la gamme de fonctionnement du procédé.

Puisque le point milieu 75 est directement connecté à une entrée, en l'occurrence l'entrée -, de l'amplificateur 80, le dispositif de traitement 35 peut évaluer la composante continue subsistant dans le signal de sortie et donc réguler le ou les organe(s) de réglage 42 de manière à annuler ou au moins limiter cette composante continue de manière contrôlée.

Il est à noter que des montages dans lesquels le point milieu 75 serait découplé électriquement de l'amplificateur 80, par exemple par un condensateur interposé entre l'entrée de l'amplificateur 80 et le point milieu, ne sont pas compatibles avec le procédé de régulation décrit dans la mesure où le dispositif de traitement n'aurait plus accès à cette composante continue en sortie de l'amplificateur, car elle serait filtrée an amont au moins en partie par le condensateur interposé, et ne pourrait donc pas la réguler comme expliqué ci-dessus. En outre, puisque le potentiel électrique du point milieu de ces montages n'est pas fixé par l'amplificateur 80, il est nécessaire d'initialiser l'amplificateur 80 au début de chaque plage temporelle d'observation du signal, ceci afin de réinitialiser les valeurs de référence de potentiel électrique utilisées par l'amplificateur 80.

Au contraire, dans un dispositif selon l'invention, une fois la boucle de régulation en régime établi, il n'est pas nécessaire de prévoir un temps d'initialisation de la sortie de l'amplificateur 80 avant de faire une évaluation de distance. En effet, la boucle de régulation présente un temps d'ajustement lent, voire très lent, par rapport à une durée d'évaluation (une rampe de fréquence d'une mesure radar). Ainsi, pour une évaluation présente, la commande des organes de réglages 42 est majoritairement définie par le comportement du système lors des évaluations passées. Le dispositif de conversion 25 selon l'invention permet donc une plus grande précision dans la mesure de paramètres de la cible C que des montages dans lesquels le point milieu 75 serait découplé électriquement de l'amplificateur 80 du fait de l'absence de temps d'initialisation. Un autre avantage de l'invention est qu'il est possible de choisir librement la fonction de transfert de la boucle de régulation ce qui permet en outre de diminuer la dynamique du signal susceptible d'être présent en entrée de l'amplificateur 80 facilitant ainsi sa réalisation

Il est à noter que dans certains modes de réalisation, le dispositif de conversion 25 est susceptible d'être intégré à un système autre qu'un lidar, pour analyser des signaux photoniques ne résultant pas de la diffusion d'un signal par une cible C.

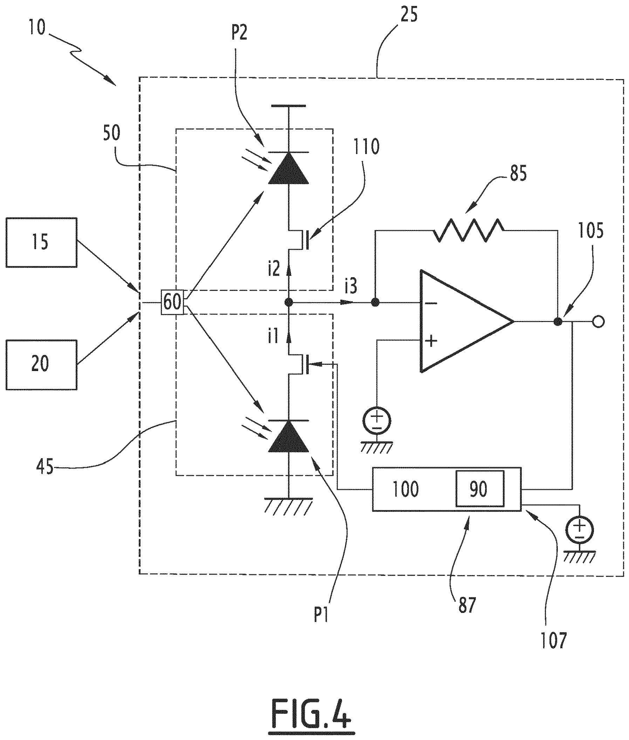

Un deuxième exemple de lidar 10 selon l'invention est représenté sur la figure 4 et va maintenant être décrit.

Les éléments identiques au premier exemple de lidar 10 ne sont pas décrits à nouveau. Seules les différences sont mises en évidence.

Chaque organe de réglage 42 est configuré pour modifier l'efficacité quantique d'une photodiode P1, P2 correspondante.

Par exemple, chaque organe de réglage 42 est configuré pour modifier une tension électrique entre l'anode et la cathode de la photodiode P1, P2 correspondante. De nombreux types de photodiodes P1, P2 présentent en effet une efficacité quantique variant en fonction de la tension entre anode et cathode de la photodiode P1, P2. Ainsi, pour un même flux photonique arrivant sur une photodiode, le courant généré par la photodiode P1, P2 varie en fonction de la tension entre anode et cathode, sur une plage de tensions entrainant une modification de l'efficacité quantique.

Chaque organe de réglage 42 comporte, par exemple, un transistor 110 connecté en série avec la photodiode P1, P2 correspondante.

Chaque transistor 110 est, par exemple, un transistor à effet de champ comportant une grille, un drain et une source, la conductance entre le drain et la source étant fonction d'une tension électrique entre la grille et la source. En régime de saturation, un tel transistor à effet de champs permet de modifier la tension de source en modifiant la tension de grille.

Chaque transistor 110 est, par exemple, connecté en série entre la photodiode P1, P2 correspondante et le point milieu 75. En particulier, le transistor 110 est configuré pour conduire le courant i1 ou i2 entre l'anode ou la cathode de la photodiode P1, P2 et le point milieu 75.

Dans ce cas, le transistor 110 appartient à la portion de circuit électrique précitée, qui était constituée par un unique conducteur dans le premier exemple.

Ainsi, du fait que les transistors 110 sont montés en suiveur, ou plus exactement selon une configuration où ils fonctionnent dans un régime de saturation, une modification de la tension de grille du transistor 110 entraîne une modification de la tension électrique de la source, ce qui entraîne également une variation du potentiel électrique de la cathode ou de l'anode de chaque photodiode P1, P2 reliée à la source du transistor 110 correspondant.

En effet, le potentiel électrique du point milieu 75, qui est connecté à l'une des entrées de l'amplificateur 80, est sensiblement fixe. Puisque par ailleurs une différence de potentiel fixe est appliquée entre les deux extrémités du circuit série contenant les deux photodiodes P1, P2, le ou les transistors 110 et le point milieu, lorsque la tension de grille de l'un des transistors 110 est modifiée, la tension entre le point milieu 75 et une des extrémités du circuit série se répartit différemment entre un transistor 110 et la photodiode P1, P2 en série, la tension drain-source augmente quand la tension aux bornes de la photodiode P1, P2 diminue et inversement.

La boucle de régulation 87 est configurée pour modifier la tension de grille d'au moins un des transistors 110. Par exemple, chaque commande générée par le contrôleur 100 lors de l'étape 210 est une tension électrique appliquée sur la grille d'un transistor 110 correspondant.

Selon l'exemple représenté sur la figure 4, deux transistors 110 sont présents.

L'un des transistors 110 est interposé entre la cathode de la photodiode P1 de la première branche de sortie 45 et le point milieu, le contrôleur 100 étant configuré pour modifier la tension de grille de ce transistor 110.

L'autre transistor 110 est interposé entre le point milieu 75 et l'anode de la photodiode P2 de la deuxième branche de sortie 50. Le dispositif de traitement 35, ou une autre source d'alimentation électrique, est configuré pour imposer une tension de grille fixe à ce transistor 110.

Ainsi, la boucle de régulation 87 modifie la tension aux bornes de l'un des transistors 110 (correspondant à la première branche de sortie 45) en fonction du signal de sortie de l'amplificateur 80, sans que la tension aux bornes de l'autre transistor 110 soit modifiée. Aussi, la tension entre cathode et anode, et donc l'efficacité quantique, de la photodiode P1 de la première branche de sortie 45 est modifiée par la boucle de régulation 87 sans que l'efficacité quantique de l'autre photodiode P2 soit modifiée. Il en résulte une modification du gain de la première branche de sortie 45 sans que le gain de la deuxième branche de sortie 50 ne soit modifiée.

De cette manière, la boucle de régulation 87 commande le transistor 110 de la première banche de sortie 45 pour diminuer la composante continue dans le courant i3.

Un avantage du deuxième exemple est que l'organe de réglage 42, constitué d'un ou plusieurs composants électroniques tels que le transistor 110, est aisé à réaliser conjointement avec le dispositif de traitement 35, sans requérir d'organe électro-optique additionnel tel qu'un atténuateur photonique.

Selon une variante, la boucle de régulation 87 du deuxième exemple est, comme celle du premier exemple, propre à modifier les gains de chacune des branches de sortie 45, 50, notamment en modifiant les tensions de grille de l'un et/ou l'autre des deux transistors 110.

En variante, chaque transistor 110 est un autre type de transistor, par exemple un transistor bipolaire comportant une base, un émetteur et un collecteur, la conductance entre l'émetteur et le collecteur étant fonction d'une tension électrique entre la base et l'émetteur. L'homme du métier saura adapter le deuxième exemple représenté sur la figure 4 à tout type de transistor.

En outre, il est à noter que d'autres méthodes pour faire varier la tension entre l'anode et la cathode des photodiodes P1, P2 sont susceptibles d'être utilisées, par exemple en déplaçant le ou les transistors 110, ou en utilisant d'autres dispositifs pour, par exemple, faire varier les potentiels électriques de la cathode de la branche 50 et/ou de l'anode de la branche 45.

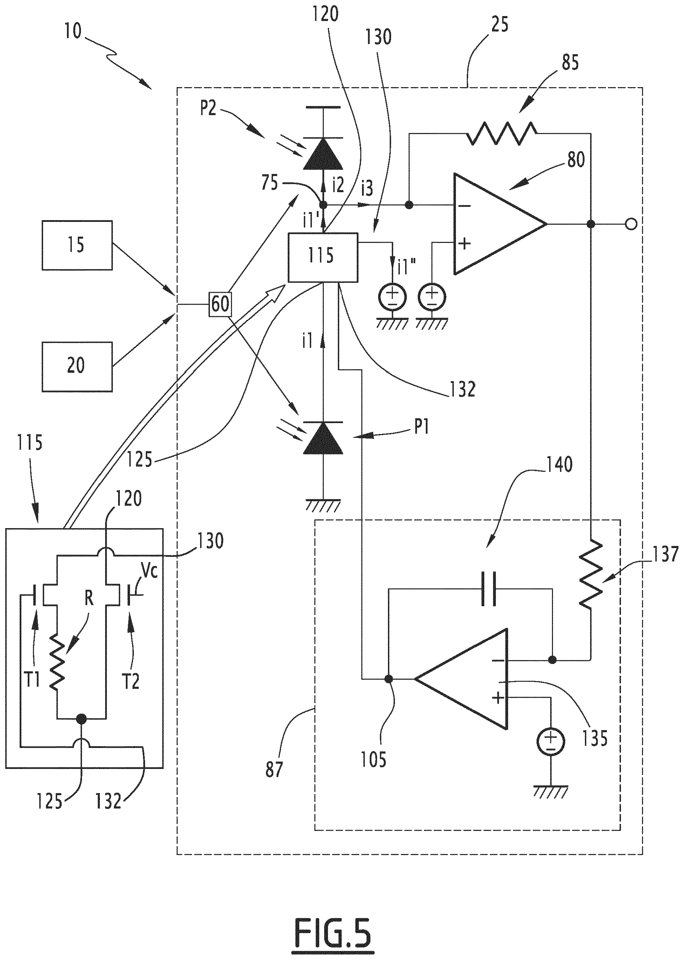

Un troisième exemple de lidar 10, représenté sur la figure 5, va maintenant être décrit. Les éléments identiques au premier exemple ne sont pas décrits à nouveau. Seules les différences sont mises en évidence.

Au moins un organe de réglage 42 comporte un séparateur de courant 115.

Le séparateur de courant 115 comporte une première borne 120, une deuxième borne 125, une troisième borne 130 et une quatrième borne 132.

Le séparateur de courant 115 est configuré pour recevoir le courant i1 de la deuxième borne 125, et pour faire passer respectivement dans chacune des première et troisième bornes 120, 130 un courant électrique i1', i1".

Chaque courant i1', i1" est formé à partir du courant i1. En particulier, le courant i1 est la somme des deux

EP 4 305 454 B1

courants i1' et i1".

En d'autres termes, le séparateur de courant 115 est configuré pour dériver une partie i1" du courant i1 et pour transmettre l'autre partie i1' du courant i1 à la borne 120.

En outre, le séparateur de courant 115 est configuré pour modifier un rapport entre les intensités des courants i1' et i1"en fonction d'une commande reçue, du contrôleur 100, par le séparateur de courant 115 sur sa quatrième borne 132. En particulier, le séparateur de courant 115 est configuré pour que ledit rapport ne soit pas ou très peu modifié par une variation de l'intensité du courant i1.

En d'autres termes, le séparateur de courant 115 est configuré pour modifier un coefficient de proportionnalité entre l'intensité de chaque courant i1' et i1" et l'intensité du courant i1, la somme des deux coefficients étant toujours égale à un.

La commande est, par exemple, une valeur de tension électrique appliquée sur l'entrée 132 du séparateur de courant 115.

La première borne 120 est électriquement connectée au point milieu 75, donc à l'entrée 77 du dispositif de traitement 35.

La deuxième borne 125 est électriquement connectée à la cathode de la photodiode P1.

La troisième borne 130 est électriquement connectée à un point présentant un potentiel électrique fixe, par exemple à la terre ou à la mi alimentation. En particulier, la troisième borne 130 est électriquement connectée à un point présentant un potentiel électrique égal à celui du point milieu 75. Toutefois, le potentiel électrique de la troisième borne 130 est susceptible de varier d'un mode de réalisation à un autre.

La boucle de régulation 87 comporte, par exemple, un amplificateur 135, un dipôle résistant 137 et un condensateur 140. L'amplificateur 135 comporte, de manière similaire à l'amplificateur 80, une entrée non inverseuse +, une entrée inverseuse - et une sortie 105.

L'entrée non-inverseuse + de l'amplificateur 135 est reliée à un point de potentiel électrique constant, par exemple reliée à la terre.

L'entrée inverseuse - de l'amplificateur 135 est reliée à la sortie 105 de l'amplificateur 80.

La sortie 105 de l'amplificateur 135 est connectée à l'entrée 132 du séparateur de courant 115.

Le dipôle résistant 137 est monté en série entre la sortie 105 de l'amplificateur 80 et l'entrée inverseuse - de l'amplificateur 135.

Une valeur de résistance électrique du dipôle résistant 137 est, par exemple, comprise entre 10 KΩ et10 MΩ.

Le condensateur 140 est connecté entre l'entrée inverseuse - et la sortie 105 de l'amplificateur 135.

Une valeur de capacité du condensateur 140 est, par exemple, comprise entre 100 femtofarad (fF) et 100 microfarad (uF).

L'amplificateur 135, le dipôle résistant 137 et le condensateur 140 forment, ensemble, un circuit intégrateur, présentant une fonction de filtrage passe-bas.

Il est à noter que de nombreux types de boucles de régulation 87 sont utilisables, notamment des boucles de régulation 87 analogiques ou numériques présentant d'autres fonctions de transfert que celle d'un simple intégrateur.

Le séparateur de courant 115 comporte par exemple un premier transistor T1 dont le drain est connecté à la borne 130 et la source à la borne 125, et un deuxième transistor T2 dont le drain est connecté à la borne 120 et la source à la borne 125, comme illustré sur un encart en partie inférieure gauche de la figure 5, ledit encart représentant le contenu du séparateur de courant 115 selon cet exemple.

La grille du premier transistor T1 est, par exemple, configurée pour recevoir une tension délivrée par le contrôleur 100 (cette tension formant alors la commande émise par le contrôleur 100) tandis qu'un potentiel électrique constant Vc est appliqué à la grille du deuxième transistor. Afin d'améliorer la précision du contrôle de dérivation de courant dans le séparateur 115, il est possible de prévoir une résistance R entre la source du premier transistor T1 et la borne 125.

Le fonctionnement du troisième exemple de lidar 10 représenté sur la figure 5 va maintenant être décrit.

Lorsque les deux photodiodes P1, P2 sont illuminées par les première ou deuxième partie du troisième signal correspondantes, les deux courants électriques i1 et i2 sont générés.

Le courant i1 est transmis par la cathode de la photodiode P1 à la deuxième borne 125.

Une partie i1' du courant i1 est transmise par le séparateur de courant 115 à la première borne 120 et circule donc jusqu'au point milieu 75. Une autre partie i1" du courant i1 est transmise à la troisième borne 130.

Le fait de dériver l'autre partie i1" du courant i1 vers la troisième borne 130 connectée au point présentant un potentiel électrique fixe permet en outre de maintenir un niveau de courant plus faible dans l'amplificateur 80 et évite des problèmes de saturation. Autrement dit, cela permet d'utiliser une résistance de rebouclage 85 respective de plus forte valeur et d'avoir un meilleur gain de conversion dans l'amplificateur 80.

En comparaison, le courant tend à augmenter dans l'amplificateur du dispositif de conversion du document US 2011/0228280 A1 de l'état de la technique, ce qui engendre des problèmes de saturation et limite le gain de conversion.

En outre, la présence du transistor T2 entre la photodiode P1 et l'entrée de l'amplificateur 80 permet là aussi de faire une adaptation d'impédance favorable. On notera qu'il est également possible d'avoir un transistor entre la

12

photodiode P2 et l'entrée de l'amplificateur 80, comme décrit dans l'exemple de la figure 4. Ainsi, l'adaptation d'impédance est d'autant plus favorable car l'impédance ramenée sur l'entrée de l'amplificateur 80 sera d'autant plus grande.

Lors de l'étape 220, le circuit électrique formé par l'amplificateur 135, le dipôle résistant 137 et le condensateur 140 filtre le signal de sortie et génère une tension qui est utilisée comme commande appliquée par exemple directement à l'entrée 132 du séparateur de courant 115.

Le séparateur de courant 115 modifie alors le rapport entre les intensités des courants i1' et i1" en fonction de la commande reçue.

Ainsi, le coefficient de proportionnalité entre l'intensité du courant i1' transmis par le séparateur 115 et l'intensité du courant i1 est modifié. Un gain de la première branche de sortie 45, défini comme étant un coefficient de proportionnalité entre l'intensité du courant i1' et la puissance optique du signal reçu par la branche 45, est donc modifié.

Il est à noter que le troisième exemple implique de dériver une partie du courant i1 afin de causer la modification du gain de la première branche de sortie 45.

Ce mode de réalisation est donc particulièrement adapté à un cas où il est d'avance connu, par exemple par construction, que le gain de l'une des deux branches est plus élevé que l'autre en l'absence de séparateur de courant 115, par exemple si une plus grande partie du signal photonique est transmise à la première branche de sortie 45 ou que le rendement de la photodiode P1 de cette branche 45 est plus élevé.

Il apparaîtra à l'homme du métier que le circuit électrique formé par l'amplificateur 135, le dipôle résistant 137 et le condensateur 140 n'est qu'un exemple de filtre parmi de nombreux filtres possibles, pouvant être réalisés aussi bien sous forme numérique qu'analogique.

Bien évidemment, le positionnement du séparateur de courant 115 dans le circuit est susceptible de varier, par exemple pour dériver une partie du courant i2 au lieu de i1.

Selon une autre variante, deux séparateurs de courant 115 sont présents, un pour chaque branche de sortie 45, 50.

Lorsqu'un séparateur de courant 115 est utilisé pour la branche 50, la première borne 120 de ce séparateur 115 est connecté à l'anode de la photodiode P1, P2 de la branche 50, la troisième borne 130 est connectée à une référence de tension, par exemple la mi-alimentation, et la deuxième borne 120 au point milieu 75.

Il est à noter qu'un dispositif de conversion comportant un séparateur de courant est utilisé dans certains lidars connus. Ces lidars comportent une première photodiode recevant le signal reçu de la cible C et délivrant un courant Is et une deuxième photodiode recevant une partie du signal émis par le lidar et délivrant un courant Ir. Un séparateur de courant est utilisé pour dériver une partie du courant Ir avant de soustraire le courant Ir' restant au courant Is généré par la première photodiode pour essayer de n'en garder que la partie variable. C'est donc la différence entre le courant Is de la première photodiode et le courant Ir' issu du séparateur qui est transmise à l'amplificateur du dispositif de conversion.

Ainsi, dans ces lidars, le séparateur de courant vise à adapter l'intensité du courant Ir (issu de la deuxième diode) représentatif du signal émis par le lidar de manière à ce que la partie continue du courant Is généré par la première diode soit supprimée en soustrayant le courant fourni par le séparateur au courant de la première diode. Les lidars comportant des séparateurs de courant connus de l'état de la technique sont donc dépourvus de l'organe de conversion 30 utilisé dans la présente invention, et notamment du séparateur photonique 60 permettant de mélanger le signal reçu de la cible C au signal émis par le lidar avant que le signal mélangé et déphasé soit transmis aux photodiodes. Cette différence est importante et permet de pallier les inconvénients de ces lidars comme expliqué ci-après.

Il est à noter que, si l'intensité du signal optique renvoyé par la cible C varie, alors la composante de courant Ir' soustraite n'est plus adaptée, il est nécessaire dans cet état de la technique de modifier la commande du séparateur de manière à adapter l'intensité du courant Ir' fourni par celui-ci pour qu'elle corresponde à la composante continue (que l'on souhaite annuler) du courant Is qui varie.

Dans des circonstances ou l'intensité du signal optique renvoyé par la cible C varie rapidement, du fait par exemple de mesures consécutives détectant des objets à des distances différentes, il peut s'avérer impossible de régler le séparateur aussi rapidement, ce qui entraîne l'apparition d'une composante continue importante dans le signal transmis à l'amplificateur et donc la saturation de celui-ci tant que la régulation du séparateur n'est pas faite.

Au contraire, dans le montage selon l'invention, l'interféromètre multi-mode utilisé en conjonction avec les deux photodiodes P1, P2 permet d'éliminer automatiquement la composante continue du signal lorsque les gains des deux branches 45 et 50 sont égaux. Même lorsque ces gains diffèrent, la proportion de composante continue dans le courant i3 ne dépend que de la différence entre ces gains et non de l'intensité du signal diffusé par la cible C. Ainsi, le montage selon l'invention permet une conversion plus précise et plus rapide du signal optique en signal électrique puisque les périodes de saturation lors de variations rapides de l'intensité du signal renvoyé par la cible C sont évitées.

Il est à noter que les différents exemples décrits précédemment comportent des amplificateurs 80 utilisant des architectures dite « differential input, single output », où une unique sortie est commandée en fonction des entrées + et - de l'amplificateur 80. Toutefois, des architectures dites « entièrement différentielles » (« fully differential » en anglais) sont également susceptibles d'être utilisées.

Dans ces architectures, l'amplificateur comporte deux sorties distinctes et commande une différence de tension entre ces deux sorties en fonction de la différence de tension entre ses deux entrées.

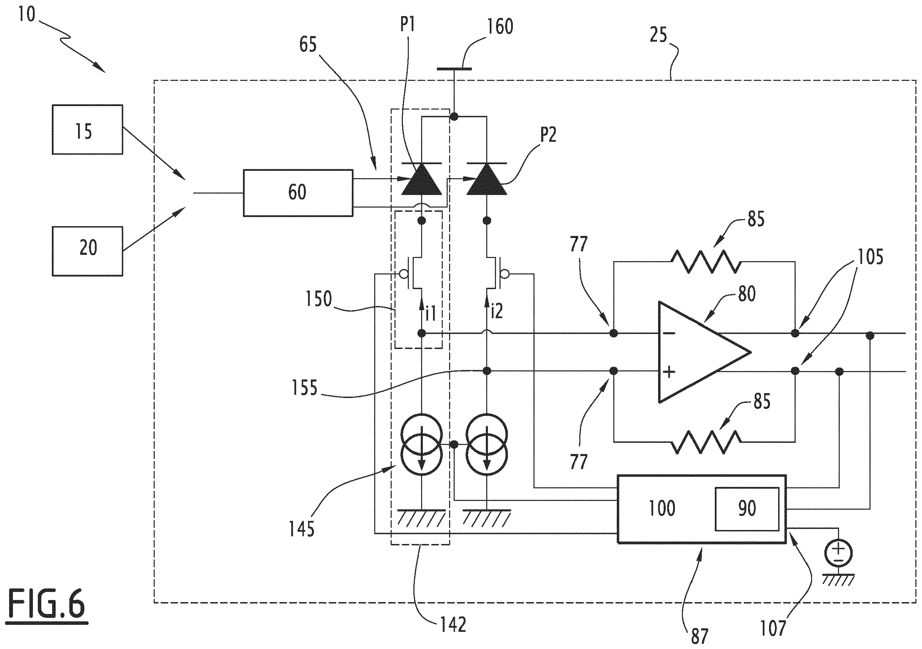

Un quatrième exemple de lidar 10 est représenté sur la figure 6.

Le quatrième exemple comporte une architecture différentielle, chaque organe de réglage 42 comportant un transistor 110 comme dans le deuxième exemple.

Les photodiodes P1, P2 ne sont plus montées en série comme dans les exemples précédents.

Par exemple, chaque branche de sortie 45, 50 comporte un circuit électrique 142 comportant successivement en série un générateur de courant 145, une portion de circuit électrique 150 et une photodiode P1, P2.

Chaque générateur de courant 145 comporte une borne reliée à la terre et une borne reliée à la portion de circuit électrique 150.

La portion de circuit électrique 150 relie le générateur de courant 145 et l'anode de la photodiode P1, P2. La portion de circuit électrique 150 est configurée pour conduire un courant électrique entre le générateur de courant 145 et l'anode de la photodiode P1, P2.

Chaque portion de circuit électrique 150 est, en outre, connectée à une entrée 77 respective du dispositif de traitement 35, de manière à permettre à la différence de courant entre le courant généré par la photodiode P1, P2 et celui généré par le générateur 145 d'être dérivée vers l'entrée 77.

Selon le mode de réalisation représenté sur la figure 6, la portion de circuit électrique 150 comprend le transistor 110 afin de permettre un contrôle de la tension aux bornes de chaque photodiode P1, P2.

La cathode de chaque photodiode P1, P2 est électriquement connectée à un point 160 porté à un potentiel électrique connu. Par exemple, une source de tension est connectée entre la terre et le point 160.

Le point 160 est, par exemple, commun aux deux circuits électriques 142. Ainsi, les deux circuits électriques 142 sont connectés électriquement en parallèle l'un de l'autre.

L'amplificateur 80 comporte deux sorties 105 distinctes, et est configuré pour générer le signal de sortie sous la forme d'une tension électrique entre les deux sorties 105.

Chacune de l'entrée non-inverseuse + et de l'entrée inverseuse - de l'amplificateur 80 est connectée à l'un des deux circuits électriques 142. En particulier, chaque entrée + ou - est connectée à un point 155 de la portion de circuit électrique 150 correspondante. En particulier, chaque entrée + et - est directement connectée à un point du circuit électrique 142 interposé entre le générateur de courant 145 et le transistor 110.

Par exemple, chaque entrée + ou - est connectée à la borne du générateur de courant 145, ou à l'extrémité de la portion 150 qui est connectée au générateur de courant 145.

Le dispositif de traitement 35 comporte deux dipôles résistants 85 distincts placés respectivement entre une sortie et une entrée de l'amplificateur.

L'amplificateur 80 est configuré pour modifier le potentiel électrique de chaque sortie 105 en fonction de l'intensité du courant reçu par l'entrée + ou - qui est reliée à une sortie 105 correspondante par un dipôle résistant 85.

En particulier, l'amplificateur 80, les résistances 85 et la boucle de régulation permet que les potentiels électriques des entrées 77 soient sensiblement égaux à une valeur prédéterminée, par exemple une valeur de référence appliquée sur une entrée 107 de l'ensemble formé, ici par le filtre 90 et le contrôleur 100, cette valeur de référence étant par exemple égale à la mi-alimentation.

Le filtre 90 est configuré pour générer un signal filtré à partir de la différence de potentiel électrique entre les deux sorties 105.

Le contrôleur 100 est configuré pour générer, en fonction du signal filtré, un signal de commande pour chaque organe de réglage 42, selon une première boucle de régulation.

En outre, le contrôleur 100 est configuré pour générer un signal de réglage identique à destination de chaque générateur de courant 145, ce signal de réglage étant propre à commander la modification de l'intensité du courant généré par le générateur de courant 145, selon une seconde boucle de régulation. Cette seconde boucle de régulation réalise une correction en offset commun. Ainsi, les courants électriques générés par les deux générateurs de courant 145 sont commandés pour correspondre approximativement à la composante continue des courants générés par les photodiodes P1, P2 dans chacun des deux circuits électriques 142. Une telle régulation est une adaptation de la technique de régulation connue sous le nom anglais de « Common Mode FeedBack », ou CMFB.

On notera que cette régulation en offset commun diffère d'une régulation en offset différentiel, telle que celle mise en oeuvre dans le document « Cohérent ePIC Receiver for 64 GBaud QPSK in 0.25pm Photonic BiCMOS Technology » (Journal of Lightwave Technology, vol. 37, n° 1, p. 103-109), réalisée en SiGe Bipolaire ayant une $f_t$=190GHz . Dans ce circuit de l'état de l'art, la régulation agit séparément sur chacun des générateurs de courant, autrement dit, il y a deux signaux de commande distincts pour les deux générateurs de courant d'offset. Au contraire, dans ce mode de réalisation décrit en relation avec la figure 6, les deux générateurs de courant 145 sont commandés par un même signal de commande afin que cette seconde boucle de régulation se combine avantageusement avec la première boucle de régulation pour obtenir un dispositif qui permet d'optimiser le rapport signal sur bruit, le fonctionnement respectif des boucles de régulation étant détaillé ci-après.

On notera que l'amplificateur 80 et les résistances 85 formant un montage couramment appelé RTIA différentiel, avec la seconde boucle de régulation permet ainsi de réguler la valeur moyenne des potentiels électriques des sorties 105, c'est-à-dire la moitié de leur somme, pour que cette moitié de somme soit égale à une valeur prédéterminée, par exemple 1,65V si l'amplificateur est alimenté entre 0 et 3,3V.

Lors du fonctionnement du dispositif de conversion, l'activation de la première boucle de régulation permet d'agir sur le gain des branches 45, 50 de manière similaire au deuxième exemple décrit précédemment. Dans l'exemple représenté en figure 4, la première boucle de régulation agit ainsi sur les transistor(s) du circuit 150 qui constituent les organes de réglage 42.

Selon un mode de réalisation, les première et seconde boucles de régulation sont activées séquentiellement. Le contrôleur 100 détermine par exemple périodiquement s'il est nécessaire d'agir sur les générateurs 145 pour modifier les intensités des courants qu'ils génèrent.

Entre deux étapes de réglage des générateurs 145, la première boucle de régulation est active et le gain de chaque branche 45, 50 est régulé par la boucle de régulation 87. En pratique, la première boucle vise à éviter que les valeurs moyennes des signaux présents sur les deux sorties 105 s'écartent l'une de l'autre. Autrement dit, les commandes générées par le contrôleur 100 assurent que les deux sorties 105 présentent chacune sensiblement les mêmes valeurs moyennes de tension.

Chaque boucle de régulation a donc son rôle, la première boucle assure que les valeurs moyennes de chacune des deux sorties soient sensiblement identiques, et la seconde boucle assure que la somme des deux sorties divisée par deux présente en moyenne une valeur prédéfinie. Ainsi, les signaux de sortie de l'amplificateur différentiel sont globalement « centrés » autour d'une valeur de tension de consigne, et l'excursion en amplitude des signaux de sortie peut ainsi être importante avant que les signaux ne saturent.

On notera que la seconde boucle de régulation n'est pas indispensable. Le circuit peut fonctionner avec uniquement la première boucle de régulation ayant pour fonction d'assurer que les deux sorties ont une même valeur moyenne et que cette valeur moyenne est égale à une valeur de tension de consigne, par exemple 1 ,65V. Ainsi, les signaux de sortie de l'amplificateur sont globalement centrés autour de la tension de consigne assurant une excursion maximale possible des signaux.

L'intérêt de la seconde boucle de régulation réside principalement dans l'ajustement optimal du point de fonctionnement en courant des photodiodes P1, P2. En effet, si la seconde boucle de régulation n'était pas présente, les générateurs de courant seraient commandés avec une commande fixe.

Dans le cas d'une commande fixe des générateurs de courants, la régulation en gain (première boucle de régulation) viendrait alors atténuer ou amplifier le signal dans la limite de la gamme accessible pour obtenir l'égalité entre les courants dans les photodiodes P1, P2 et les courants dans les générateurs de courant, ceci afin que le courant dérivé vers le RTIA depuis les branches 142 soit en moyenne nul. La puissance du signal photonique entrant dans le guide 40, ainsi que les dispersions du séparateur 60 et des diodes P1, P2 n'étant pas connues, il faudrait alors que le courant imposé par les générateurs de courant 145 corresponde à un pire cas statistique (notamment lié aux dispersions technologiques) et un pire cas de fonctionnement (notamment lié aux variations de puissance d'entrée) pour que la régulation en gain puisse fonctionner. Ceci est sous-optimal par rapport à une solution utilisant une boucle de régulation de type CMFB qui va permettre de s'adapter à la puissance photonique entrant dans le guide 40 et aux dispersions réelle du circuit en cours d'utilisation.

La seconde boucle de régulation permet ainsi de trouver le courant maximal acceptable dans les générateurs de courant permettant de remplir les conditions de fonctionnement (c.a.d un bon fonctionnement de la première boucle de régulation). Plus le courant dans les photodiodes P1, P2 est élevé, plus l'amplitude du signal utile sera élevée, permettant d'avoir in fine un meilleur rapport signal sur bruit du signal de sortie de l'amplificateur différentiel. Comme dans le cas des architectures « single », la régulation en boucle fermée sur le ou les gains permet, sur une plage de puissance d'entrée reçue par les photodiodes P1, P2, d'éviter la saturation de l'amplificateur 80 provoquée par les dispersions des composants des différentes branches 45 et 50, l'imperfection du séparateur 60 et donc d'amplifier plus fortement la partie variable du signal photonique que ne le permettent les montages de l'état de la technique.

En outre, et non des moindres, la boucle de régulation en gain, dans les différents exemples de réalisation décrits précédemment, permet d'avoir un dispositif insensible aux variations de puissance de l'étage d'émission 15 sur une plage donnée de puissance du signal photonique, en permettant de corriger d'éventuelles différences initiales (avant régulation) de gain individuel entre les première et deuxième branches de sortie et une éventuelle imperfection du séparateur 60. On notera que cela n'est en pratique pas possible dans le cas où une seule boucle de régulation en offset est utilisée, quel que soit le montage, avec une unique sortie ou avec deux sorties différentielles.

Selon un autre mode de réalisation du circuit représenté en figure 6, les première et seconde boucles de régulation sont en permanence actives. Afin d'éviter que l'action d'une boucle contrarie l'action de l'autre boucle, on peut prévoir une certaine forme d'asymétrie de réponse fréquentielle/temporelle, pour privilégier l'action d'une des boucles sur une plage donnée de fréquence de régulation. A titre indicatif, on pourra par exemple « privilégier » la seconde boucle de régulation en offset commun, en utilisant un filtre passe-bas pour cette deuxième boucle qui présente une fréquence de coupure (par exemple 100kHz) plus haute que celle du filtre passe-bas de la première boucle de régulation (par exemple 10kHz).

Comme cette seconde boucle de régulation agit en décalant les deux tensions de sorties (105), ce qui correspond à une régulation de type CMFB, elle ne peut pas éliminer le signal AC utile. La bande passante de cette seconde boucle de régulation n'a donc pas pour obligation d'être inférieure à la bande de fréquence du signal utile AC.

Le signal utile AC considéré en sortie de l'amplificateur 80 correspond en pratique au signal hétérodyne obtenu pour un lidar de type FMCW. Le signal hétérodyne présente par exemple une plage de fréquences utiles comprises entre 100kHz et 100MHz quand la période de balayage fréquentiel (« chirp period ») est de 10microsecondes, et que l'on réalise une fenêtre d'observation du signal présent sur la ou les sortie-s 105 sur une durée minimale correspondant à la durée d'un balayage fréquentiel.

De façon générale, il est important de noter que la première boucle de régulation du dispositif présentant un amplificateur avec des sorties différentielles, et l'unique boucle de régulation des dispositifs présentant un amplificateur avec une unique sortie vise à réaliser une régulation en gain. Une régulation en gain vise à assurer que la composante continue du courant dans la branche 45, appelée I1dc, et la composante continue du courant dans la branche 50, appelée I2dc, sont sensiblement égales (I1dc=I2dc). Ce type de régulation est à différentier d'une régulation en offset pour laquelle on cherche à définir, avec un courant d'offset Iref (cas d'une sortie unique) ou deux courants Iref1 et Iref2 (cas avec deux sorties différentielles), appliqué(s) par un ou des générateur(s) de courant d'offset, des courants tel(s) que I1dc-I2dc=Iref (sortie unique) ou I1dc=Iref1 et I2dc=Iref2 (sorties différentielles), avec Iref ou Iref1 et Iref2 non nulle(s) par construction des circuits. Ce type de régulation en offset est utilisé abondamment dans les dispositifs de l'art antérieur et présente l'inconvénient majeur de ne pas permettre au système d'être insensible aux variations rapides de puissance du signal photonique car la ou les valeurs Iref sont définies par une régulation nécessairement lente et qui ne fonctionnera bien que pour une valeur de puissance donnée du signal photonique à analyser. Au contraire, avec la régulation en gain, l'égalité des composantes continues I1dc vet I2dc est conservé quelle que soit la puissance d'entrée, à l'intérieur d'une plage de puissances du troisième signal photonique prédéfinie par construction. Ainsi, pour un dispositif lidar du type FMCW, la plage de puissance d'entrée considérée est définie à partir de la plage de puissance du signal laser émis correspondant sur la plage de fréquences balayées, en tenant compte d'un ratio correspondant au ratio de puissance entre la puissance du laser émis et la puissance de la partie du laser dérivé vers le dispositif de conversion 25.

Comme on le voit ici, le montage en architecture « single » du deuxième exemple est aisément adaptable à une architecture différentielle. Il apparaîtra à l'homme du métier que les autres exemples de lidars décrits dans la présente description sont également susceptibles d'être mis en oeuvre avec une architecture différentielle.

Les architectures différentielles présentent un intérêt particulier dans les environnements et les installations présentant un bruit électrique ou électromagnétique élevé, puisqu'elles sont moins sensibles à de tels bruits que les architectures « single ».

Il est à noter que, bien que le quatrième exemple ait été décrit dans le cas où l'organe de réglage 42 est un transistor dans la portion de circuit électrique 150, ce type d'architecture est également susceptible d'être utilisé avec d'autres types d'organes de réglage 42, par exemple avec des atténuateurs/amplificateurs du flux photonique, ou des séparateurs de courant, comme les organes de réglage des premier ou troisième exemples de réalisation décrits supra.

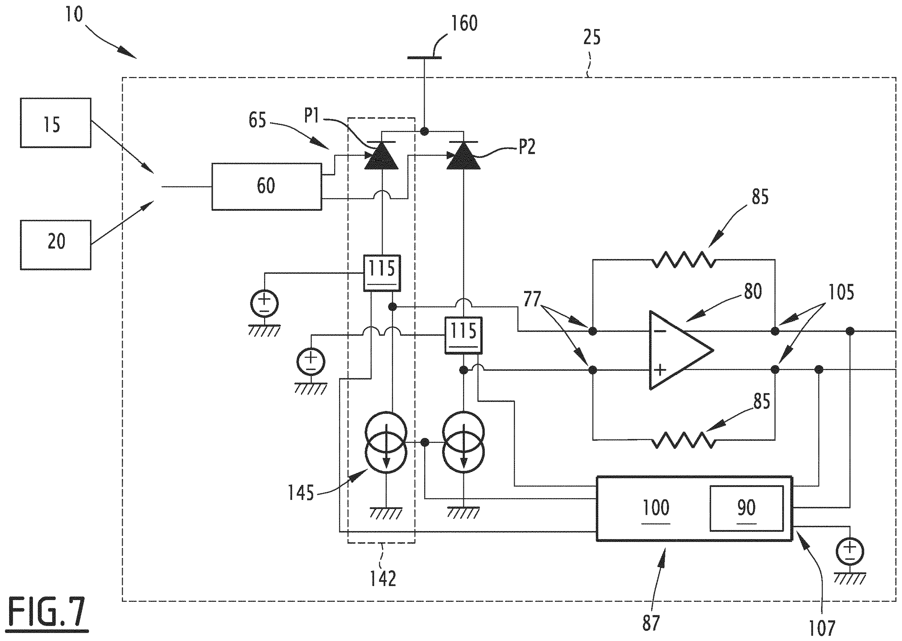

La figure 7 représente ainsi une variante de la figure 6 établie à partir de l'exemple de la figure 5, où chaque portion de circuit 150 représentée à la figure 6 a été remplacée sur la figure 7 par un séparateur de courant 115 respectif.

Dans des modes de réalisation ne comportant pas de transistor 110, la portion de circuit électrique 150 est, par exemple, formée par un conducteur électrique reliant le générateur de courant 145 et l'anode de la photodiode P1, P2.

De façon générale, un dispositif de conversion selon l'invention peut comporter un ou plusieurs organes de réglage 42. Chaque organe de réglage peut être placé soit dans la partie photonique après le séparateur 60 pour réaliser une atténuation ou une amplification du flux photonique dans une branche de sortie, soit dans la partie électrique pour réaliser de même une atténuation ou une amplification du courant délivré par une des photodiodes P1, P2 d'une branche de sortie.

Dans le cas où un seul organe de réglage est prévu dans le dispositif de conversion, il est nécessaire en pratique de s'assurer que la plage de variations de gain dans la branche de sortie intégrant l'organe de réglage permettra de s'adapter à toutes les valeurs possibles du gain intrinsèque de l'autre branche de sortie (dont le gain ne peut être modifié).

Si la plage de modification du gain par l'organe de réglage est faible, ou si elle est unidirectionnelle, c'est-à-dire adaptation du gain uniquement à la baisse (avec un atténuateur) ou à la hausse (amplificateur), il sera vraisemblablement nécessaire de dissymétriser légèrement les puissances injectées dans les branches de sortie après le séparateur 60.

Ainsi, par exemple, si on utilise un seul atténuateur dans une des branches de sortie, et que les autres éléments des branches de sortie sont de conception identique, alors il sera nécessaire d'envoyer un peu plus de puissance dans la branche de sortie ayant l'atténuateur pour s'assurer que la puissance traversant la branche de sortie avec atténuateur ne soit pas initialement (avant atténuation) plus basse que la puissance traversant la branche de sortie sans atténuateur, afin de pouvoir mettre en oeuvre la régulation et de régler le taux d'atténuation permettant in fine d'égaliser les courants sortant des branches de sortie de l'organe de conversion 30.

Dans le cas où deux dispositifs de réglage sont prévus, avec un dispositif de réglage par branche de sortie, alors le séparateur 60 devra préférentiellement répartir le flux de manière égale entre les différentes branches de sortie, la boucle de régulation en gain sera de préférence conçue pour privilégier une action sur l'un ou l'autre des dispositifs de réglage de sorte à maximiser le courant fourni par chacune des branches de sortie, pour avoir un meilleur rapport signal sur bruit dans le signal utile sortant de l'amplificateur différentiel sur la ou les sorties 105.

En outre, dans le cas ou plusieurs dispositifs de réglage sont utilisés, deux, trois ou davantage encore, alors il est souhaitable que la boucle de régulation agisse à un moment donné sur un seul des dispositifs de réglage en le choisissant comme expliqué ci-dessus, de sorte à maximiser le courant de sortie de chaque branche de sortie.

Par ailleurs, bien que les exemples de réalisation susmentionnées utilisent un amplificateur différentiel, avec deux entrées différentielles, l'homme de l'art peut aisément adapter les circuits proposés pour utiliser un amplificateur single, avec une unique entrée. Les exemples avec un amplificateur différentiel ont été privilégiés car ils sont en pratique bien plus robuste que ceux avec un amplificateur single.

Il est à noter que, dans les exemples de lidar présentés ci-dessus, un unique couple de branches de sorte 45, 50 est présent.

Il apparaîtra à l'homme du métier que le nombre de couples de branches de sortie 45, 50 est susceptible d'être supérieur à 1, les branches de sortie d'un même couple étant déphasées d'environ 180° l'une par rapport à l'autre.

En particulier, les branches de sortie des différents couples présentent des déphasages différents.

Par exemple, deux couples de branches de sortie 45, 50 sont présents, la branche 50 du premier couple étant déphasée d'environ 180° par rapport à la branche 45 du premier couple, la branche 45 du deuxième couple étant déphasée d'environ 90° par rapport à la branche 45 du premier couple, la branche 50 du deuxième couple étant déphasée d'environ 270° par rapport à la branche 45 du premier couple.

Lorsque les couples sont au nombre de quatre, les déphasages sont par exemple de 0°, 45°, 90°, 135°, 180°, 225°, 270° et 315°, et ainsi de suite.

Il est à noter que de manière générale les déphasages entre les différents couples de branches de sortie 45, 50 sont susceptibles de varier, tant que le déphasage entre les deux branches de chaque couple reste aussi proche que possible de 180°.

Chaque couple de branches de sortie 45, 50 est, par exemple, associé à un dispositif de traitement 35 respectif générant un courant électrique de sortie en fonction des signaux photoniques en sortie des branches 45, 50 du couple considéré.

Les signaux de sortie des différents dispositifs de traitement 35 sont analysés par un ou plusieurs dispositifs d'analyse 27 correspondants pour calculer des valeurs d'un ou plusieurs paramètres de la cible C.

Bien qu'un unique dispositif de conversion 25 comportant un unique séparateur 60 ait été décrit précédemment, il est à noter que des modes de réalisation dans lequel un dispositif de conversion comporte une pluralité de dispositifs de conversion 25 élémentaires, chaque dispositif de conversion élémentaire 25 étant tel que décrit précédemment, sont également envisageables.

Dans ce cas, chaque dispositif de conversion élémentaire 25 reçoit le ou les mêmes signaux photoniques d'entrée.

Par exemple, chaque dispositif de conversion élémentaire 25 comporte un séparateur 60 dédié alimentant les deux branches 45, 50 du dispositif de conversion élémentaire. En variante, un unique séparateur 60 commun à tous les dispositifs de conversion élémentaires 25 génère des couples de signaux de sortie du séparateur 60, chaque signal d'un couple étant déphasé de 180° environ par rapport à l'autre signal du couple, et transmet le couple de signaux de sortie aux branches 45, 50 du dispositif de conversion élémentaire 25 correspondant.

Par ailleurs, on notera que dans la description précédente des modes de réalisation, l'amplificateur délivrant le signal de sortie 105 a été référencé avec la référence 80 sans les résistances de rebouclage 85. En pratique, l'amplificateur différentiel 80 avec les résistances de rebouclage 85 constitue un schéma d'amplificateur de type RTIA. Comme l'homme de l'art l'aura compris, dans les explications données supra, un raccourci a régulièrement été fait pour désigner l'ensemble RTIA comme l'amplificateur du montage, notamment dans toutes les explications sur les mécanismes de régulation.

## Revendications

1. Dispositif de conversion d'un signal photonique à analyser, le dispositif de conversion (25) comportant :

   - un organe de conversion photonique-électrique (30), et
   - un dispositif électronique de traitement (35),

l'organe de conversion (30) comportant un séparateur (60) présentant deux sorties reliées respectivement à une première branche de sortie (45) et à une deuxième branche de sortie (50), le séparateur (60) comportant une ou deux entrées pour recevoir respectivement un ou deux signaux photoniques d'entrée, le séparateur (60) réalisant le mélange des signaux photoniques d'entrée dans le cas où deux entrées sont présentes, l'unique signal d'entrée photonique reçu ou le mélange des deux signaux photoniques reçus correspondant à un signal photonique à analyser, le séparateur (60) conduisant une première partie du signal photonique à analyser à la première branche de sortie (45) et conduisant une deuxième partie du signal photonique à analyser à la deuxième branche de sortie (50), l'organe de conversion (30) étant configuré pour imposer, via le séparateur, un déphasage d'environ 180 degrés entre la première et la deuxième partie du signal photonique à analyser, chaque première ou deuxième branche de sortie (45, 50) comportant une portion (65) de guide d'onde et une photodiode (P1, P2), chaque photodiode (P1, P2) étant configurée pour générer un premier courant électrique (i1, i2) respectif en réponse à la réception de la première ou deuxième partie du signal photonique à analyser,

chaque branche de sortie (45, 50) étant configurée pour générer en sortie un deuxième courant électrique (i1, i1', i2) présentant une intensité égale ou multiple d'une intensité du premier courant électrique (i1, i2) de la branche de sortie (45, 50) considérée, le dispositif de traitement (35) comprenant un amplificateur (80) configuré pour générer au moins un signal de sortie en fonction d'une différence entre les intensités des deux deuxièmes courants électriques (i1, i1', i2) ,

un gain étant défini pour chaque branche de sortie (45, 50), le gain étant un coefficient de proportionnalité entre l'intensité du deuxième courant électrique (i1, i1', i2) de la branche de sortie (45, 50) considérée et une puissance photonique de la première ou deuxième partie du signal photonique à analyser reçue par ladite branche de sortie (45, 50),

le dispositif de conversion (25) comportant au moins un organe de réglage (42) commandé électroniquement et apte à modifier un des gains, le dispositif de traitement (35) comportant une première boucle de régulation (87) comprenant un filtre passe-bas (90) et un dispositif (100) de commande de chaque organe de réglage (42), la boucle de régulation (87) recevant ledit signal de sortie dudit amplificateur (80) et produisant un signal électrique de commande de chaque organe de réglage (42) de sorte à réguler la valeur moyenne de chaque signal de sortie à une valeur de consigne prédéfinie correspondant à l'égalisation des composantes continues des intensités des deux deuxièmes courants électriques (i1, i1', i2),

l'amplificateur (80) étant un amplificateur différentiel (80) présentant une première entrée (+) et une seconde entrée (-),

au moins un organe de réglage (42) comportant un séparateur de courant (115), le séparateur de courant (115) étant positionné entre une photodiode (P1, P2) d'une branche donnée et un point intermédiaire (75) électriquement connecté à une entrée respective de l'amplificateur différentiel (80), le séparateur de courant (115) étant configuré pour modifier un coefficient de proportionnalité entre les intensités du premier courant (i1) et d'un deuxième courant (i1') de ladite branche donnée,

le séparateur de courant (115) comportant une première borne (120) connectée au point intermédiaire (75), une deuxième borne (125) connectée à l'anode ou la cathode d'une des photodiodes (P1, P2) et une troisième borne (130) connectée à un point présentant un potentiel électrique fixe, et le séparateur de courant (115) étant configuré pour transmettre à la première borne (120) une partie (i1') d'un courant (i1) reçu de la deuxième borne (125) et pour transmettre à la troisième borne (130) une autre partie (i1") du courant (i1) reçu de deuxième borne (125),

**caractérisé en ce que**

le séparateur de courant (115) comportant un premier transistor (T1) connecté à la deuxième borne (125) et à la troisième borne (130), un deuxième transistor (T2) connecté à la première borne (120) et à la deuxième borne (125), et une résistance (R) entre la source du premier transistor (T1) et la deuxième borne (125) ; la grille du premier transistor (T1) étant configurée pour recevoir une tension délivrée par ledit dispositif de commande (100), tandis qu'un potentiel électrique constant (Vc) est appliqué à la grille du deuxième transistor (T2).

2. Dispositif de conversion selon la revendication 1, dans lequel chaque organe de réglage (42) est configuré pour modifier un coefficient de proportionnalité entre l'intensité du premier courant électrique de la branche de sortie correspondante et la puissance photonique de la première ou deuxième partie du signal photonique à analyser reçue par ladite branche de sortie (45, 50).

3. Dispositif de conversion selon la revendication 1 ou 2, dans lequel il est défini un facteur de transmission photonique pour chaque branche de sortie (45, 50), au moins un organe de réglage (42) étant configuré pour modifier le facteur de transmission photonique de la branche de sortie (45, 50) correspondante.

4. Dispositif de conversion selon la revendication 1 ou 2, dans lequel chaque photodiode (P1, P2) présente une efficacité quantique, le dispositif de conversion (25) comprend un deuxième organe de réglage (42) configuré pour modifier l'efficacité quantique d'une photodiode (P1, P2) correspondante.

5. Dispositif de conversion selon la revendication 4, dans lequel chaque photodiode (P1, P2) présente une anode et une cathode, au moins un organe de réglage (42) étant configuré pour modifier une tension électrique entre l'anode et la cathode de la photodiode (P1, P2) correspondante.

6. Dispositif de conversion selon la revendication 5, dans lequel au moins un organe de réglage (42) comporte un transistor (110) monté en série avec la photodiode (P1, P2) de la branche de sortie (45, 50) correspondante, le transistor (110) comportant une grille ou une base, la boucle de régulation (87) étant configurée pour modifier une tension de grille ou de base du transistor (110).

7. Dispositif de conversion selon l'une quelconque des revendications précédentes, dans lequel la première entrée (+) de l'amplificateur différentiel (80) est reliée à une référence de tension, les photodiodes (P1, P2) des deux branches de sortie (45, 50) étant montées en série dans le même sens l'une avec l'autre, l'anode de l'une étant reliée à la cathode de l'autre, par l'intermédiaire du séparateur de courant (115), la seconde entrée (-) de l'amplificateur différentiel (80) étant électriquement connectée au point intermédiaire (75).

8. Dispositif de conversion selon la revendication 6, dans lequel le transistor (110) relie la photodiode (P1, P2) de la branche de sortie (45, 50) correspondante et le point intermédiaire (75) électriquement connecté à la seconde entrée (-) de l'amplificateur différentiel (80).

9. Dispositif de conversion selon l'une quelconque des revendications 1 à 5, dans lequel chaque branche de sortie (45, 50) comporte un générateur de courant (145) monté en série avec la photodiode (P1, P2) correspondante, chaque générateur de courant (145) étant relié à la photodiode (P1, P2) par un séparateur de courant (115) respectif, distincte, l'amplificateur différentiel (80) présentant des première et seconde entrées (+, -) connectées chacune respectivement à un point intermédiaire (155) connecté à un séparateur de courant (115) respectif , et dans lequel l'amplificateur différentiel (80) est configuré pour générer deux signaux de sortie, et comprenant en outre une deuxième boucle de régulation (87) recevant les deux signaux de sortie dudit amplificateur (80) et produisant un signal électrique de commande commun desdits générateurs de courant (145) de sorte à réguler la moyenne des tensions présentes sur les deux sorties à une valeur de consigne prédéfinie, la première boucle de régulation (87) produisant un signal électrique de commande d'au moins un organe de réglage (42) de sorte à réguler la moyenne de chaque tension présente sur une des sorties à une même valeur de consigne prédéfinie correspondant à l'égalisation des composantes continues des intensités des deuxièmes courants.

10. Dispositif de conversion comportant plusieurs dispositifs de conversion (25) élémentaires selon l'une quelconque des revendications 1 à 9, dans lequel le ou les mêmes signaux photoniques d'entrée sont introduits dans chaque dispositif de conversion élémentaire (25), les séparateurs de chacun des dispositifs étant différents ou constituant un même et unique séparateur (60) partagé par les dispositifs de conversion (25), le ou les séparateurs (60) formant une pluralité de couples de signaux de sorties, chaque couple de signaux de sortie étant associé à un dispositif de conversion élémentaire (25) et introduit dans les première et deuxième branche de sortie (45, 50) respectives du dispositif de conversion élémentaires (25) associé, les signaux d'un même couple présentant un déphasage d'environ 180 degrés l'un par rapport à l'autre, les signaux de couples différents présentant un déphasage les uns par rapport aux autres, et dans lequel les signaux de sortie des amplificateurs (80) des dispositifs de conversion élémentaires (25) sont transmis à un dispositif d'analyse (27).

11. Dispositif de conversion selon la revendication 10, comportant deux dispositifs de conversion élémentaires (25), et dans lequel les quatre signaux de sortie du ou des séparateurs sont en quadrature de phase.

12. Lidar comportant un étage (15) d'émission d'un signal photonique vers une cible (C), un étage (20) de réception d'un signal photonique diffusé par la cible (C) et un dispositif de conversion (25) selon l'une quelconque des revendications précédentes, l'étage d'émission (15) étant configuré pour injecter une partie du signal émis dans une des entrées du séparateur (60) ou dans un guide d'onde formant une branche d'entrée (40) reliée à une entrée du séparateur (60), l'étage de réception (20) étant configuré pour injecter le signal diffusé dans une autre entrée du séparateur (60) ou dans ledit guide d'onde formant ladite branche d'entrée (40), le signal photonique à analyser étant formé par le mélange des signaux injectés dans les deux entrées du séparateur (60) ou dans ledit guide d'onde formant la branche d'entrée (40).

**13.** Procédé de commande d'un dispositif de conversion (25) comportant :

- un organe de conversion photonique-électrique (30), et
- un dispositif électronique de traitement (35),

l'organe de conversion (30) comportant un séparateur (60) présentant deux sorties reliées respectivement à une première branche de sortie (45) et à une deuxième branche de sortie (50), le séparateur (60) comportant une ou deux entrées pour recevoir respectivement un ou deux signaux photoniques d'entrée, le séparateur (60) réalisant le mélange des signaux photoniques d'entrée dans le cas où deux entrées sont présentes, l'unique signal d'entrée reçu ou le mélange des signaux correspondant à un signal photonique à analyser, le séparateur (60) conduisant une première partie du signal photonique à analyser à la première branche de sortie (45) et conduisant une deuxième partie du signal photonique à analyser à la deuxième branche de sortie (50), l'organe de conversion (30) étant configuré, via le séparateur (60), pour imposer un déphasage de 180 degrés environ entre la première et la deuxième partie du signal photonique à analyser, chaque première ou deuxième branche de sortie (45, 50) comportant une portion (65) de guide d'onde et une photodiode (P1, P2),
chaque photodiode (P1, P2) étant configurée pour générer un premier courant électrique (i1, i2) respectif en réponse à la réception de la première ou deuxième partie du signal photonique à analyser,
chaque branche de sortie (45, 50) étant configurée pour générer en sortie un deuxième courant électrique (i1, i1', i2) présentant une intensité égale ou multiple d'une intensité du premier courant électrique (i1, i2) de la branche de sortie (45, 50) considérée, le dispositif de traitement (35) comprenant un amplificateur (80) configuré pour générer au moins un signal de sortie en fonction d'une différence entre les intensités des deux deuxièmes courants électriques (i1, i1', i2), l'amplificateur (80) étant un amplificateur différentiel (80) présentant une première entrée (+) et une seconde entrée (-),
un gain étant défini pour chaque branche de sortie (45, 50), le gain étant un coefficient de proportionnalité entre l'intensité du deuxième courant électrique (i1, i1', i2) de la branche de sortie (45, 50) considérée et une puissance photonique de la première ou deuxième partie du signal photonique à analyser reçue par ladite branche de sortie (45, 50),
le procédé comportant des étapes de :

- filtrage (200) passe-bas, par une boucle de régulation (87), du signal de sortie pour obtenir un signal filtré,
- génération (210), par la boucle de régulation (87), en fonction du signal filtré, d'un signal électrique de commande d'au moins un organe de réglage (42) commandé électroniquement, et
- transmission (220) de la commande à l'organe de réglage (42) et modification d'un des premiers gains par l'organe de réglage (42) en fonction de la commande reçue, de sorte à réguler la valeur moyenne de chaque signal de sortie à une valeur de consigne prédéfinie correspondant à l'égalisation des composantes continues des intensités des deux deuxièmes courants électriques (i1, i1', i2),

au moins un organe de réglage (42) comportant un séparateur de courant (115), le séparateur de courant (115) étant positionné entre une photodiode (P1, P2) d'une branche donnée et un point intermédiaire (75) électriquement connecté à une entrée respective de l'amplificateur différentiel (80), le séparateur de courant (115) modifiant un coefficient de proportionnalité entre les intensités du premier courant (i1) et d'un deuxième courant (i1') de ladite branche donnée,
le séparateur de courant (115) comportant une première borne (120) connectée au point intermédiaire (75), une deuxième borne (125) connectée à l'anode ou la cathode d'une des photodiodes (P1, P2) et une troisième borne (130) connectée à un point présentant un potentiel électrique fixe, et le séparateur de courant (115) transmettant à la première borne (120) une partie (i1') d'un courant (i1) reçu de la deuxième borne (125) et transmettant à la troisième borne (130) une autre partie (i1") du courant (i1) reçu de deuxième borne (125),
**caractérisé en ce que**
le séparateur de courant (115) comportant un premier transistor (T1) connecté à la deuxième borne (125) et à la troisième borne (130), un deuxième transistor (T2) connecté à la première borne (120) et à la deuxième borne (125), et une résistance (R) entre la source du premier transistor (T1) et la deuxième borne (125) ; la grille du premier transistor (T1) étant configurée pour recevoir une tension délivrée par ledit dispositif de commande (100), tandis qu'un potentiel électrique constant (Vc) est appliqué à la grille du deuxième transistor (T2).

**Patentansprüche**

**1.** Vorrichtung zur Umwandlung eines zu analysierenden photonischen Signals, die Umwandlungsvorrichtung (25) umfassend:

- ein photonisch-elektrisches Wandlerelement (30), und
- eine elektronische Verarbeitungsvorrichtung (35),

das Wandlerelement (30) umfassend einen Splitter (60), der zwei Ausgänge aufweist, die jeweils mit einem ersten Ausgangszweig (45) und einem zweiten Ausgangszweig (50) verbunden sind, der Splitter (60) umfassend einen oder zwei Eingänge zum Empfangen von jeweils einem oder zwei photonischen Eingangssignalen, wobei der Splitter (60) die Mischung der photonischen Eingangssignale in dem Fall durchführt, dass zwei Eingänge vorhanden sind, das einzige empfangene photonische Eingangssignal oder die Mischung der zwei empfangenen photonischen Signale einem zu analysierenden photonischen Signal entsprechen, der Splitter (60) einen ersten Teil des zu analysierenden photonischen Signals zu dem ersten Ausgangszweig (45) leitet und einen zweiten Teil des zu analysierenden photonischen Signals zu dem zweiten Ausgangszweig (50) leitet, wobei das Wandlerelement (30) konfiguriert ist, um über den Splitter eine Phasenverschiebung von etwa 180 Grad zwischen dem ersten und dem zweiten Teil des zu analysierenden photonischen Signals zu erzwingen, jeder erste oder zweite Ausgangszweig (45, 50) einen Wellenleiterabschnitt (65) und eine Fotodiode (P1, P2) umfasst, jede Fotodiode (P1, P2) konfiguriert ist, um als Reaktion auf den Empfang des ersten oder zweiten Teils des zu analysierenden photonischen Signals einen jeweiligen ersten elektrischen Strom ($i1$, $i2$) zu erzeugen, jeder Ausgangszweig (45, 50) konfiguriert ist, um an dem Ausgang einen zweiten elektrischen Strom ($i1$, $i1'$, $i2$) zu erzeugen, der eine Stromstärke aufweist, die gleich wie eine oder ein Vielfaches einer Stromstärke des ersten elektrischen Stroms ($i1$, $i2$) des betrachteten Ausgangszweigs (45, 50) ist, die Verarbeitungsvorrichtung (35) umfassend einen Verstärker (80), der konfiguriert ist, um abhängig von einer Differenz zwischen den Stromstärken der zwei zweiten elektrischen Ströme ($i1$, $i1'$, $i2$) mindestens ein Ausgangssignal zu erzeugen, wobei eine Verstärkung für jeden Ausgangszweig (45, 50) definiert ist, wobei die Verstärkung ein Proportionalitätskoeffizient zwischen der Stromstärke des zweiten elektrischen Stroms ($i1$, $i1'$, $i2$) des betrachteten Ausgangszweigs (45, 50) und einer photonischen Leistung des ersten oder zweiten Teils des zu analysierenden photonischen Signals ist, die von dem Ausgangszweig (45, 50) empfangen wird, die Umwandlungsvorrichtung (25) umfassend mindestens ein elektronisch gesteuertes Regelelement (42), das geeignet ist, um eine der Verstärkungen zu ändern, die Verarbeitungsvorrichtung (35) umfassend eine erste Regelschleife (87), umfassend einen Tiefpassfilter (90) und eine Vorrichtung (100) zum Steuern von jedem Regelelement (42), wobei die Regelschleife (87) das Ausgangssignal des Verstärkers (80) empfängt und ein elektrisches Signal zum Steuern jedes Regelelements (42) erzeugt, um den Mittelwert von jedem Ausgangssignal auf einen vordefinierten Sollwert zu regeln, der dem Ausgleich der Gleichstromkomponenten der Stromstärken der zwei zweiten elektrischen Ströme ($i1$, $i1'$, $i2$) entspricht, wobei der Verstärker (80) ein Differenzverstärker (80) ist, der einen ersten Eingang (+) und einen zweiten Eingang (-) aufweist, mindestens ein Regelelement (42), umfassend Stromteiler (115), wobei der Stromteiler (115) zwischen einer Fotodiode (P1, P2) eines gegebenen Zweigs und einem Zwischenpunkt (75), der elektrisch mit einem jeweiligen Eingang des Differenzverstärkers (80) verbunden ist, positioniert ist, wobei der Stromteiler (115) konfiguriert ist, um einen Proportionalitätskoeffizienten zwischen den Stromstärken des ersten Stroms ($i1$) und eines zweiten Stroms ($i1'$) des gegebenen Zweigs zu ändern, der Stromteiler (115) umfassend einen ersten Anschluss (120), der mit dem Zwischenpunkt (75) verbunden ist, einen zweiten Anschluss (125), der mit der Anode oder Kathode einer der Fotodioden (P1, P2) verbunden ist, und einen dritten Anschluss (130), der mit einem Punkt verbunden ist, der ein festes elektrisches Potential aufweist, und wobei der Stromteiler (115) konfiguriert ist, um einen Teil ($i1'$) eines von dem zweiten Anschluss (125) empfangenen Stroms ($i1$) an den ersten Anschluss (120) zu übertragen und einen anderen Teil ($i1"$) des von dem zweiten Anschluss (125) empfangenen Stroms ($i1$) an den dritten Anschluss (130) zu übertragen, **dadurch gekennzeichnet, dass** der Stromteiler (115) einen ersten Transistor (T1), der mit dem zweiten Anschluss (125) und dem dritten Anschluss (130) verbunden ist, einen zweiten Transistor (T2), der mit dem ersten Anschluss (120) und dem zweiten Anschluss (125) verbunden ist, und einen Widerstand (R) zwischen der Source des ersten Transistors (T1) und dem zweiten Anschluss (125) umfasst; wobei das Gate des ersten Transistors (T1) konfiguriert ist, um eine von der Steuervorrichtung (100) bereitgestellte Spannung zu empfangen, während ein konstantes elektrisches Potential (Vc) an das Gate des zweiten Transistors (T2) angelegt ist.

2. Umwandlungsvorrichtung nach Anspruch 1, wobei jedes Regelelement (42) konfiguriert ist, um einen Proportionalitätskoeffizienten zwischen der Stromstärke des ersten elektrischen Stroms des entsprechenden Ausgangszweigs und der photonischen Leistung des ersten oder zweiten Teils des zu analysierenden photonischen Signals, der von dem Ausgangszweig (45, 50) empfangen wird, zu ändern.

3. Umwandlungsvorrichtung nach Anspruch 1 oder 2, wobei für jeden Ausgangszweig (45, 50) ein photonischer Transmissionsfaktor definiert ist, wobei mindestens ein Regelelement (42) konfiguriert ist, um den Photonischen Transmissionsfaktor des entsprechenden Ausgangszweigs (45, 50) zu ändern.

4. Umwandlungsvorrichtung nach Anspruch 1 oder 2, wobei jede Fotodiode (P1, P2) eine Quanteneffizienz aufweist, die Umwandlungsvorrichtung (25) ein zweites Regelelement (42) umfasst, das konfiguriert ist, um die Quanteneffizienz einer entsprechenden Fotodiode (P1, P2) zu ändern.

5. Umwandlungsvorrichtung nach Anspruch 4, wobei jede Fotodiode (P1, P2) eine Anode und eine Kathode aufweist, wobei mindestens ein Regelelement (42) konfiguriert ist, um eine elektrische Spannung zwischen der Anode und der Kathode der entsprechenden Fotodiode (P1, P2) zu ändern.

6. Umwandlungsvorrichtung nach Anspruch 5, wobei mindestens ein Regelelement (42) einen Transistor (110) umfasst, der mit der Fotodiode (P1, P2) des entsprechenden Ausgangszweigs (45, 50) in Reihe verbunden ist, der Transistor (110) umfassend ein Gate oder eine Basis aufweist, wobei die Regelschleife (87) konfiguriert ist, um eine Gate- oder Basisspannung des Transistors (110) zu ändern.

7. Umwandlungsvorrichtung nach einem der vorherigen Ansprüche, wobei der erste Eingang (+) des Differenzverstärkers (80) mit einer Spannungsreferenz verbunden ist, wobei die Fotodioden (P1, P2) der zwei Ausgangszweige (45, 50) in der gleichen Richtung zueinander in Reihe verbunden sind, wobei die Anode des einen über den Stromteiler (115) mit der Kathode des anderen verbunden ist, wobei der zweite Eingang (-) des Differenzverstärkers (80) elektrisch mit dem Zwischenpunkt (75) verbunden ist.

8. Umwandlungsvorrichtung nach Anspruch 6, wobei der Transistor (110) die Fotodiode (P1, P2) des entsprechenden Ausgangszweigs (45, 50) und den Zwischenpunkt (75), der elektrisch mit dem zweiten Eingang (-) des Differenzverstärkers (80) verbunden ist, miteinander verbindet.

9. Umwandlungsvorrichtung nach einem der Ansprüche 1 bis 5, wobei jeder Ausgangszweig (45, 50) einen Stromgenerator (145) umfasst, der mit der entsprechenden Fotodiode (P1, P2) in Reihe verbunden ist, wobei jeder Stromgenerator (145) über einen jeweiligen separaten Stromteiler (115) mit der Fotodiode (P1, P2) verbunden ist, der Differenzverstärker (80) einen ersten und einen zweiten Eingang (+, -) aufweist, die jeweils mit einem Zwischenpunkt (155) verbunden sind, der mit einem jeweiligen Stromteiler (115) verbunden ist, und wobei der Differenzverstärker (80) konfiguriert ist, um zwei Ausgangssignale zu erzeugen, und ferner umfassend eine zweite Regelschleife (87), die die zwei Ausgangssignale des Verstärkers (80) empfängt und ein gemeinsames elektrisches Steuersignal der Stromgeneratoren (145) erzeugt, um den Mittelwert der an den zwei Ausgängen vorhandenen Spannungen auf einen vordefinierten Sollwert zu regeln, wobei die erste Regelschleife (87) ein elektrisches Steuersignal für mindestens ein Regelelement (42) erzeugt, um den Mittelwert von jeder an einem der Ausgänge anliegenden Spannung auf einen gleichen vordefinierten Sollwert zu regeln, der dem Ausgleich der Gleichstromkomponenten der Stromstärken der zweiten Ströme entspricht.

10. Umwandlungsvorrichtung, umfassend mehrere elementare Umwandlungsvorrichtungen (25) nach einem der Ansprüche 1 bis 9, wobei das oder die gleichen photonischen Eingangssignale in jede elementare Umwandlungsvorrichtung (25) eingegeben werden, wobei die Splitter jeder der Vorrichtungen verschieden sind oder einen einzigen und gleichen Splitter (60) darstellen, der von den Umwandlungsvorrichtungen (25) gemeinsam genutzt wird, wobei der oder die Splitter (60) eine Vielzahl von Ausgangssignalpaaren bilden, wobei jedes Paar von Ausgangssignalen mit einer elementaren Umwandlungsvorrichtung (25) assoziiert ist und in den jeweiligen ersten und zweiten Ausgangszweig (45, 50) der assoziierten elementaren Umwandlungsvorrichtung (25) eingegeben wird, wobei die Signale eines Paars eine Phasenverschiebung von etwa 180 Grad in Bezug aufeinander aufweisen, die Signale verschiedener Paare eine Phasenverschiebung in Bezug aufeinander aufweisen, und wobei die Ausgangssignale der Verstärker (80) der elementaren Umwandlungsvorrichtungen (25) an eine Analysevorrichtung (27) übertragen werden.

11. Umwandlungsvorrichtung nach Anspruch 10, umfassend zwei elementare Umwandlungsvorrichtungen (25), und wobei die vier Ausgangssignale des oder der Splitter um 90 Grad phasenverschoben sind.

12. Lidar, umfassend eine Stufe (15) zum Senden eines photonischen Signals zu einem Ziel (C), eine Stufe (20) zum Empfangen eines photonischen Signals, das von dem Ziel (C) gestreut wird, und eine Umwandlungsvorrichtung (25) nach einem der vorherigen Ansprüche, wobei die Sendestufe (15) konfiguriert ist, um einen Teil des gesendeten Signals in einen der Eingänge des Splitters (60) oder in einen Wellenleiter einzuspeisen, der einen Eingangszweig (40) bildet, der mit einem Eingang des Splitters (60) verbunden ist, wobei die Empfangsstufe (20) konfiguriert ist, um das gestreute Signal in einen anderen Eingang des Splitters (60) oder in den Wellenleiter, der den Eingangszweig (40) bildet, einzuspeisen, wobei das zu analysierende photonische Signal durch die Mischung der Signale gebildet wird, die in die zwei Eingänge des Splitters (60) oder in den Wellenleiter, der den Eingangszweig (40) bildet, eingespeist werden.

13. Verfahren zum Steuern einer Umwandlungsvorrichtung (25), umfassend:

- ein photonisch-elektrisches Wandlerelement (30), und
- eine elektronische Verarbeitungsvorrichtung (35),

das Wandlerelement (30) umfassend einen Splitter (60), der zwei Ausgänge aufweist, die jeweils mit einem ersten Ausgangszweig (45) und einem zweiten Ausgangszweig (50) verbunden sind, der Splitter (60) umfassend einen oder zwei Eingänge zum Empfangen von jeweils einem oder zwei photonischen Eingangssignalen, wobei der Splitter (60) die Mischung der photonischen Eingangssignale in dem Fall durchführt, dass zwei Eingänge vorhanden sind, das einzige empfangene Eingangssignal oder die Mischung der zwei Signale einem zu analysierenden photonischen Signal entsprechen, der Splitter (60) einen ersten Teil des zu analysierenden photonischen Signals zu dem ersten Ausgangszweig (45) leitet und einen zweiten Teil des zu analysierenden photonischen Signals zu dem zweiten Ausgangszweig (50) leitet, wobei das Wandlerelement (30) über den Splitter (60) konfiguriert ist, um eine Phasenverschiebung von etwa 180 Grad zwischen dem ersten und dem zweiten Teil des zu analysierenden photonischen Signals zu erzwingen, jeder erste oder zweite Ausgangszweig (45, 50) einen Wellenleiterabschnitt (65) und eine Fotodiode (P1, P2) umfasst,

jede Fotodiode (P1, P2) konfiguriert ist, um als Reaktion auf den Empfang des ersten oder zweiten Teils des zu analysierenden photonischen Signals einen jeweiligen ersten elektrischen Strom (i1, i2) zu erzeugen, jeder Ausgangszweig (45, 50) konfiguriert ist, um an dem Ausgang einen zweiten elektrischen Strom (i1, i1', i2) zu erzeugen, der eine Stromstärke aufweist, die gleich wie eine oder ein Vielfaches einer Stromstärke des ersten elektrischen Stroms (i1, i2) des betrachteten Ausgangszweigs (45, 50) ist, die Verarbeitungsvorrichtung (35) umfassend einen Verstärker (80), der konfiguriert ist, um abhängig von einer Differenz zwischen den Stromstärken der zwei zweiten elektrischen Ströme (i1, i1', i2) mindestens ein Ausgangssignal zu erzeugen, wobei der Verstärker (80) ein Differenzverstärker (80) ist, der einen ersten Eingang (+) und einen zweiten Eingang (-) aufweist,

wobei eine Verstärkung für jeden Ausgangszweig (45, 50) definiert ist, wobei die Verstärkung ein Proportionalitätskoeffizient zwischen der Stromstärke des zweiten elektrischen Stroms (i1, i1', i2) des betrachteten Ausgangszweigs (45, 50) und einer photonischen Leistung des ersten oder zweiten Teils des zu analysierenden photonischen Signals ist, die von dem Ausgangszweig (45, 50) empfangen wird,

das Verfahren umfassend die folgenden Schritte:

- Tiefpassfilterung (200), durch eine Regelschleife (87), des Ausgangssignals, um ein gefiltertes Signal zu erlangen,
- Erzeugen (210), durch die Regelschleife (87), abhängig von dem gefilterten Signal eines elektrischen Signals zum Steuern mindestens eines elektronisch gesteuerten Regelelements (42), und
- Übertragen (220) des Befehls an das Regelelement (42) und Ändern einer der ersten Verstärkungen durch das Regelelement (42) abhängig von dem empfangenen Befehl, um den Mittelwert von jedem Ausgangssignal auf einen vordefinierten Sollwert zu regeln, der dem Ausgleich der Gleichstromkomponenten der Stromstärken der zwei zweiten elektrischen Ströme(i1, i 1', i2) entspricht,

mindestens ein Regelelement (42), umfassend einen Stromteiler (115), wobei der Stromteiler (115) zwischen einer Fotodiode (P1, P2) eines gegebenen Zweigs und einem Zwischenpunkt (75), der elektrisch mit einem jeweiligen Eingang des Differenzverstärkers (80) verbunden ist, positioniert ist, der Stromteiler (115) einen Proportionalitätskoeffizienten zwischen den Stromstärken des ersten Stroms (i1) und eines zweiten Stroms (i1') des gegebenen Zweigs ändert,

der Stromteiler (115) umfassend einen ersten Anschluss (120), der mit dem Zwischenpunkt (75) verbunden ist, einen zweiten Anschluss (125), der mit der Anode oder Kathode einer der Fotodioden (P1, P2) verbunden ist, und einen dritten Anschluss (130), der mit einem Punkt verbunden ist, der ein festes elektrisches Potential aufweist, und wobei der Stromteiler (115) einen Teil (i1') eines von dem zweiten Anschluss (125) empfangenen Stroms (i1) an den ersten Anschluss (120) überträgt und einen anderen Teil (i1") des von dem zweiten Anschluss (125) empfangenen Stroms (i1) an den dritten Anschluss (130) überträgt,

**dadurch gekennzeichnet, dass** der Stromteiler (115) einen ersten Transistor (T1), der mit dem zweiten Anschluss (125) und dem dritten Anschluss (130) verbunden ist, einen zweiten Transistor (T2), der mit dem ersten Anschluss (120) und dem zweiten Anschluss (125) verbunden ist, und einen Widerstand (R) zwischen der Source des ersten Transistors (T1) und dem zweiten Anschluss (125) umfasst; wobei das Gate des ersten Transistors (T1) konfiguriert ist, um eine von der Steuervorrichtung (100) bereitgestellte Spannung zu empfangen, während ein konstantes elektrisches Potential (Vc) an das Gate des zweiten Transistors (T2) angelegt ist.

**Claims**

1. A conversion device for converting a photonic signal to be analyzed, the conversion device (25) including:

    - a photonic-electric conversion element (30), and
    - an electronic processing device (35),
    the conversion element (30) including a splitter (60) having two outputs connected to a first output branch (45) and to a second output branch (50), respectively, the splitter (60) including one or two inputs for receiving one or two input photonic signals, respectively, the splitter (60) mixing the input photonic signals in the case where two inputs are present, the single received photonic input signal or the mixing of the two received photonic signals corresponding to a photonic signal to be analyzed, the splitter (60) leading a first part of the photonic signal to be analyzed to the first output branch (45) and leading a second part of the photonic signal to be analyzed to the second output branch (50), the conversion elements (30) being configured for imposing, via the splitter, a phase shift of approximately 180 degrees between the first and the second portions of the photonic signal to be analyzed, each first or second output branch (45, 50) including a waveguide portion (65) and a photodiode (P1, P2),
    each photodiode (P1, P2) being configured for generate a respective first electrical current (i1, i2) in response to receiving the first or second part of the photonic signal to be analyzed,
    each output branch (45, 50) being configured for generating at the output, a second electrical current (i1, i1', i2) having a value equal to or a multiple of a value of the first electrical current (i1, i2) of the output branch (45, 50) considered, the processing device (35) comprising an amplifier (80) configured for generating at least one output signal according to a difference between the values of the two second electrical currents (i1, i1', i2),
    a gain being defined for each output branch (45, 50), the gain being a coefficient of proportionality between the value of the second electrical current (i1, i1', i2) of the output branch (45, 50) considered and a photonic power of the first or second part of the photonic signal to be analyzed, received by said output branch (45, 50),
    the conversion device (25) including at least one electronically controlled adjustment element (42), apt to modify one of the gains, the processing device (35) including a first regulation loop (87) comprising a low-pass filter (90) and a control device (100) for controlling each adjustment element (42), the regulation loop (87) receiving said output signal from said amplifier (80) and producing an electrical control signal for each adjustment element (42) so as to regulate the mean value of each output signal to a predefined setpoint value corresponding to the equalization of the DC components of the values of the two second electrical currents (i1, i1', i2),
    the amplifier (80) being a differential amplifier (80) having a first input (+) and a second input (-),
    at least one adjustment element (42) including a current splitter (115), the current splitter (115) being positioned between a photodiode (P1, P2) of a given branch and an intermediate point (75) electrically connected to a respective input of the differential amplifier (80), the current splitter (115) being configured for modifying a coefficient of proportionality between the values of the first current (i1) and of a second current (i1') of said given branch,
    the current splitter (115) including a first terminal (120) connected to the intermediate point (75), a second terminal (125) connected to the anode or the cathode of one of the photodiodes (P1, P2) and a third terminal (130) connected to a point having a fixed electrical potential, and the current splitter (115) being configured for transmitting to the first terminal (120), a part (i1') of a current (i1) received from the second terminal (125) and for transmitting to the third terminal (130) another part (i1") of the current (i1) received from the second terminal (125),
    **characterized in that** the current splitter (115) includes a first transistor (T1) connected to the second terminal (125) and to the third terminal (130), a second transistor (T2) connected to the first terminal (120) and to the second terminal (125), and a resistor (R) between the source of the first transistor (T1) and the second terminal (125); the gate of the first transistor (T1) being configured to receive a voltage supplied by said control device (100), while a constant electrical potential (Vc) is applied to the gate of the second transistor (T2).

2. The conversion device according to claim 1, wherein each adjustment element (42) is configured for modifying a coefficient of proportionality between the value of the first electrical current of the corresponding output branch and the photonic power of the first or second part of the photonic signal to be analyzed received by said output branch (45, 50).

3. The conversion device according to claim 1 or 2, wherein a photon transmittance is defined for each output branch (45, 50), at least one adjustment element (42) being configured for modifying the photon transmittance of the corresponding output branch (45, 50).

4. The conversion device according to claim 1 or 2, wherein each photodiode (P1, P2) has a quantum efficiency, the conversion device (25) comprising a second adjustment element (42) configured for modifying the quantum efficiency of a corresponding photodiode (P1, P2).

5. The conversion device according to claim 4, wherein each photodiode (P1, P2) has an anode and a cathode, at least one adjustment element (42) being configured for modifying an electrical voltage between the anode and the cathode of the corresponding photodiode (P1, P2).

6. The conversion device according to claim 5, wherein at least one adjustment element (42) includes a transistor (110) connected in series with the photodiode (P1, P2) of the corresponding output branch (45, 50), the transistor (110) including a gate or a base, the regulation loop (87) being configured for modifying a gate voltage or a base voltage of the transistor (110).

7. The conversion device according to any of the preceding claims, wherein the first input (+) of the differential amplifier (80) is connected to a voltage reference, the photodiodes (P1, P2) of the two output branches (45, 50) being connected in series in the same direction with each other, the anode of one photodiode being connected to the cathode of the other, via the current splitter (115), the second input (-) of the differential amplifier (80) being electrically connected to the intermediate point (75).

8. The conversion device according to claim 6, wherein the transistor (110) connects the photodiode (P1, P2) of the corresponding output branch (45, 50) and the intermediate point (75) electrically connected to the second input (-) of the differential amplifier (80).

9. The conversion device according to any of claims 1 to 5, wherein each output branch (45, 50) includes a current generator (145) connected in series with the corresponding photodiode (P1, P2), each current generator (145) being connected to the distinct photodiode (P1, P2) by a respective current splitter (115), the differential amplifier (80) having first and second (+, -) inputs, each connected correspondingly connected to an intermediate point (155) connected to a respective current splitter (115), and wherein the differential amplifier (80) is configured for generating two output signals, and further comprising a second regulation loop (87) receiving the two output signals of said amplifier (80) and producing a common electrical control signal of said current generators (145) so as to regulate the average of the voltages present on the two outputs to a predefined setpoint value, the first regulating loop (87) producing an electrical control signal for at least one adjustment element (42) so as to regulate the average of each voltage present on one of the outputs to the same predefined setpoint value corresponding to the equalization of the DC components of the values of the values of the second currents.

10. The conversion device including a plurality of elementary conversion devices (25) according to any of claims 1 to 9, wherein the same input photonic signal or signals are fed into each elementary conversion device (25), the splitters of each of the devices being different or forming a single splitter (60) shared by the conversion devices (25), the splitter or splitters (60) forming a plurality of pairs of output signals, each pair of output signals being associated with an elementary conversion device (25) and fed into the respective first and second output branches (45, 50) of the associated elementary conversion device (25), the signals of the same pair having a phase shift of approximately 180 degrees with respect to each other, the signals of different pairs having a phase shift with respect to each other, and wherein the output signals of the amplifiers (80) of the elementary conversion devices (25) are transmitted to an analysis device (27).

11. The conversion device according to claim 10, including two elementary conversion devices (25), and wherein the four output signals of the at least one splitter are in phase quadrature.

12. A lidar including a stage (15) for transmitting a photonic signal to a target (C), a stage (20) for receiving a photonic signal scattered by the target (C) and a conversion device (25) according to any of the preceding claims, the transmission stage (15) being configured for injecting a part of the transmitted signal into one of the inputs of the splitter (60) or into a waveguide forming an input branch (40) connected to an input of the splitter (60), the reception stage (20) being configured for injecting the scattered signal into another input of the splitter (60) or into said waveguide forming said input branch (40), the photonic signal to be analyzed being formed by mixing the signals injected into the two inputs of the splitter (60) or into said waveguide forming the input branch (40).

13. A method for controlling a conversion device (25) including:

- a photonic-electric conversion element (30), and
- an electronic processing device (35),
the conversion element (30) including a splitter (60) having two outputs connected to a first output branch (45) and to a second output branch (50), respectively, the splitter (60) including one or two inputs for receiving one or two input photonic signals, respectively, the splitter (60) mixing the input photonic signals in the case where two inputs are present, the single received input signal or the mixing of the signals corresponding to a photonic signal to be analyzed, the splitter (60) leading a first part of the photonic signal to be analyzed to the first output branch (45) and leading a second part of the photonic signal to be analyzed to the second output branch (50), the conversion elements (30) being configured for imposing, via the splitter (60), a phase shift of approximately 180 degrees between the first and the second parts of the photonic signal to be analyzed, each first or second output branch (45, 50) including a waveguide portion (65) and a photodiode (P1, P2),
each photodiode (P1, P2) being configured for generating a respective first electrical current (i1, i2) in response to receiving the first or second part of the photonic signal to be analyzed,
each output branch (45, 50) being configured for generating a second electrical current (i1, i1', i2) having a value equal to or multiple of a value of the first electrical current (i1, i2) of the output branch (45, 50) considered, the processing device (35) comprising an amplifier (80) configured for generating at least one output signal according to a difference between the values of the two second electrical currents (i1, i1', i2), the amplifier (80) being a differential amplifier (80) having a first input (+) and a second input (-),
a gain being defined for each output branch (45, 50), the gain being a coefficient of proportionality between the value of the second electrical current (i1, i1', i2) of the output branch (45, 50) considered and a photonic power of the first or second part of the photonic signal to be analyzed, received by said output branch (45, 50),
the method including the steps of:

- low-pass filtering (200), by a regulation loop (87), of the output signal, for obtaining a filtered signal,
- generation (210), by the regulation loop (87), as a function of the filtered signal, of an electrical control signal of at least one electronically controlled adjustment element (42), and
- transmission (220) of the control to the adjustment element (42) and modification of one of the first gains by the adjustment element (42) depending on the control received, so as to regulate the mean value of each output signal to a predefined setpoint value corresponding to the equalization of the DC components of the values of the two second electrical currents (i1, i1', i2),

at least one adjustment element (42) including a current splitter (115), the current splitter (115) being positioned between a photodiode (P1, P2) of a given branch and an intermediate point (75) electrically connected to a respective input of the differential amplifier (80), the current splitter (115) modifying a coefficient of proportionality between the values of the first current (i1) and of a second current (i1') of said given branch,
the current splitter (115) including a first terminal (120) connected to the intermediate point (75), a second terminal (125) connected to the anode or the cathode of one of the photodiodes (P1, P2) and a third terminal (130) connected to a point having a fixed electrical potential, and the current splitter (115) transmitting to the first terminal (120), a part (i1') of a current (i1) received from the second terminal (125) and transmitting to the third terminal (130), another part (i1") of the current (i1) received from the second terminal (125),
**characterized in that** the current splitter (115) includes a first transistor (T1) connected to the second terminal (125) and to the third terminal (130), a second transistor (T2) connected to the first terminal (120) and to the second terminal (125), and a resistor (R) between the source of the first transistor (T1) and the second terminal (125); the gate of the first transistor (T1) being configured to receive a voltage supplied by said control device (100), while a constant electrical potential (Vc) is applied to the gate of the second transistor (T2).

FIG.1

**FIG.2**

**FIG.3**

## FIG.4

## FIG.5

FIG.6

EP 4 305 454 B1

FIG.7

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20110228280 A1

**Littérature non-brevet citée dans la description**

- *Journal of Lightwave Technology,* vol. 37 (1), 103-109